(19)

Europäisches Patentamt
European Patent Office
Office européen des brevets

(11)  **EP 4 727 304 A1**

(12)  **EUROPEAN PATENT APPLICATION**
published in accordance with Art. 153(4) EPC

(43)  Date of publication:
**15.04.2026 Bulletin 2026/16**

(21)  Application number: **23957281.1**

(22)  Date of filing: **02.11.2023**

(51)  International Patent Classification (IPC):
***H10H 20/853*** (2025.01)

(86)  International application number:
**PCT/CN2023/129436**

(87)  International publication number:
**WO 2025/091412 (08.05.2025 Gazette 2025/19)**

(84)  Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71)  Applicants:
 • **Boe Technology Group Co., Ltd.
  Beijing 100015 (CN)**
 • **Hefei Boe Ruisheng Technology Co., Ltd.
  Hefei, Anhui 230012 (CN)**

(72)  Inventors:
 • **LV, Chaoren
  Beijing 100176 (CN)**

 • **QIN, Jianwei
  Beijing 100176 (CN)**
 • **FU, Bao
  Beijing 100176 (CN)**
 • **TANG, Hai
  Beijing 100176 (CN)**
 • **SUN, Yiding
  Beijing 100176 (CN)**
 • **QI, Qi
  Beijing 100176 (CN)**
 • **ZHANG, Qian
  Beijing 100176 (CN)**

(74)  Representative: **Hoffmann Eitle
  Patent- und Rechtsanwälte PartmbB
  Arabellastraße 30
  81925 München (DE)**

(54)  **LIGHT-EMITTING SUBSTRATE, BACKLIGHT MODULE, AND DISPLAY DEVICE**

(57)  Disclosed is a light-emitting substrate. The light-emitting substrate comprises a base, and a pad group, a light-emitting chip, a signal line group, and a protective structure which are located on the base. The pad group is connected to the light-emitting chip. The signal line group at least comprises two signal lines correspondingly connected to the pad group, the orthographic projection of the signal lines on the base has a first contour, the first contour comprises a plurality of sequentially connected edges, and any two connected edges have an intersection point. The protective structure is located on the side of the light-emitting chip away from the base, and the orthographic projection of the light-emitting chip on the base is located in the orthographic projection of the protective structure on the base. The orthographic projection of the protective structure on the base has a second contour. The intersection point comprises a target first intersection point located in the second contour and having the minimum distance from the second contour, and a safe distance is formed between the target first intersection point and the second contour; and/or the intersection point comprises a target second intersection point located outside the second contour and having the minimum distance from the second contour, and a safe distance is formed between the target second intersection point and the second contour.

FIG. 9

## Description

### TECHNICAL FIELD

The present disclosure relates to the field of display technologies, and in particular, to a light-emitting substrate, a backlight module and a display apparatus.

### BACKGROUND

Mini light-emitting diode (mini LED)/micro light-emitting diode (micro LED) display apparatuses have advantages such as high luminance, sharp display images and low power consumption, and have a good application prospect.

### SUMMARY

In an aspect, a light-emitting substrate is provided. The light-emitting substrate includes a substrate, and a pad group, a light-emitting chip, a signal line group, and a protective structure that are located on the substrate. The pad group includes two pads respectively connected to two pins of the light-emitting chip. The signal line group includes two signal lines at least, the two signal lines are respectively connected to the two pads of the pad group, any adjacent signal lines have a gap therebetween, an orthographic projection of any signal line of the signal line group on the substrate has a first contour, the first contour includes a plurality of edges that are sequentially connected, any edge is a line without a corner point, any two connected edges have an intersection, and extension directions of the two edges at the intersection have an angle. The protective structure is located on a side of the light-emitting chip away from the substrate. An orthographic projection of the light-emitting chip on the substrate is located in an orthographic projection of the protective structure on the substrate. The orthographic projection of the protective structure on the substrate has a second contour, intersections include a target first intersection located inside of the second contour and having a minimum distance from the second contour, and the target first intersection has a safe distance from the second contour, and/or the intersections further include a target second intersection located outside of the second contour and having a minimum distance from the second contour, and the target second intersection has a safe distance from the second contour.

In some embodiments, the second contour includes a plurality of first portions and a plurality of second portions that are alternately connected end to end, any first portion is located in an orthographic projection of a signal line of the signal line group on the substrate, and a second portion is non-overlapping with the orthographic projection of any signal line of the signal line group on the substrate; a sum of lengths of the plurality of first portions is greater than a sum of lengths of the plurality of second portions.

In some embodiments, the second contour is in a shape of a circle, and a ratio of a length L1 of the second portion to a circumference C of the second contour satisfies a following formula:

$$\frac{L1}{C} \leq \frac{\cos^{-1}\frac{R-d}{R}}{180},$$

where R is a radius of the second contour, and d is a length of the safe distance.

In some embodiments, the second contour is in a shape of a circle, and a ratio of a length L1 of the second portion to a circumference C of the second contour satisfies a following formula:

$$\frac{L1}{C} \geq \frac{90°-\cos^{-1}\frac{G}{2R}}{180},$$

where R is a radius of the second contour, and G is a distance between two signal lines of the signal line group.

In some embodiments, a signal line connected to a pad is divided into a plurality of sub-portions connected in sequence, and extension directions of two sub-portions connected to each other intersect. In the plurality of sub-portions, a sub-portion connected to the pad is a first sub-portion, and in an arrangement direction of the two pads of the pad group, a width of the first sub-portion is greater than a length of the pad.

In some embodiments, a remaining sub-portion in the plurality of sub-portions except the first sub-portion is a second sub-portion. A width of the second sub-portion is less than or equal to the width of the first sub-portion.

In some embodiments, the second contour includes a plurality of first portions and a plurality of second portions that are alternately connected end to end, any first portion is located in an orthographic projection of a signal line of the signal line group on the substrate, and a second portion is non-overlapping with the orthographic projection of any signal line of the signal line group on the substrate; a sum of lengths of the plurality of first portions is less than a sum of lengths of the plurality of second portions.

In some embodiments, a signal line connected to a pad is divided into a plurality of sub-portions connected in sequence, and extension directions of two sub-portions connected to each other intersect. The plurality of sub-portions include a third sub-portion, an orthographic projection of the third sub-portion on the substrate is non-overlapping with the orthographic projection of the protective structure on the substrate, and the third sub-portion has a safe distance from the second contour.

In some embodiments, a signal line connected to a pad includes at least three sub-portions connected in sequence inside of the second contour, and extension directions of two sub-portions connected to each other intersect.

In some embodiments, multiple sub-portions, inside of the second contour, of at least one signal line connected to the pad group are arranged surrounding at least a portion of the light-emitting chip connected to the pad group.

In some embodiments, the signal line connected to the pad is divided into the plurality of sub-portions connected in sequence, and extension directions of two sub-portions connected to each other intersect. In the plurality of sub-portions, a sub-portion connected to the pad is a first sub-portion, and in a direction perpendicular to an extension direction of the first sub-portion, a width of the first sub-portion is substantially equal to a length of the pad.

In some embodiments, widths of any two sub-portions of a same signal line are substantially equal.

In some embodiments, a length of the safe distance is greater than or equal to 0.3 mm.

In some embodiments, the light-emitting substrate further includes a reflective layer, the reflective layer is located on a side of a signal line away from the substrate. The reflective layer includes a hollow region, and an orthographic projection of a pad on the substrate is located in an orthographic projection of the hollow region on the substrate.

In some embodiments, a thickness of a signal line is greater than or equal to 20 μm.

In some embodiments, a contour of a cross-section of the protective structure along a plane perpendicular to the substrate protrudes toward a direction away from the substrate.

In another aspect, a backlight module is provided. The backlight module includes the light-emitting substrate according to any one of the above embodiments.

In yet another aspect, a display apparatus is provided. The display apparatus includes a liquid crystal display panel and the backlight module according to any one of the above embodiments. The liquid crystal display panel is located on a light exit side of the backlight module.

In still yet another aspect, a display apparatus is provided. The display apparatus includes the light-emitting substrate according to any one of the above embodiments.

BRIEF DESCRIPTION OF THE DRAWINGS

In order to describe the technical solutions in the present disclosure more clearly, the accompanying drawings to be used in some embodiments of the present disclosure will be briefly introduced below. Obviously, the accompanying drawings to be described below are merely drawings of some embodiments of the present disclosure, and a person of ordinary skill in the art can obtain other drawings according to those drawings. In addition, the accompanying drawings in the following description may be regarded as schematic diagrams, but are not limitations on actual sizes of products, actual processes of methods and actual timings of signals involved in the embodiments of the present disclosure.

FIG. 1 is a top view of a display apparatus, in accordance with some embodiments;
FIG. 2 is a structural diagram of a display apparatus, in accordance with some embodiments;
FIG. 3 is a structural diagram of a display apparatus, in accordance with some other embodiments;
FIG. 4 is a partial structural diagram of a light-emitting substrate, in accordance with some possible implementations;
FIG. 5 is a sectional view taken along the line A-A' in FIG. 4;
FIG. 6 is a partial structural diagram of a light-emitting substrate, in accordance with some other possible implementations;
FIG. 7 is a sectional view taken along the line B-B' in FIG. 6;
FIG. 8 is a structural diagram showing a region of a light-emitting substrate that is covered by red ink after performing a reliability test on the light-emitting substrate under a high temperature and high humidity, in accordance with some possible implementations;
FIG. 9 is a partial structural diagram of a light-emitting substrate, in accordance with some embodiments;
FIG. 10 is a partial enlarged view of the region F in FIG. 9;
FIG. 11 is a partial structural diagram of a light-emitting substrate, in accordance with some other embodiments;
FIG. 12 is a partial enlarged view of the region E in FIG. 11;
FIG. 13 is a partial structural diagram of a light-emitting substrate, in accordance with still some other embodiments;
FIG. 14 is a partial structural diagram of a light-emitting substrate, in accordance with yet still some other embodiments;
FIG. 15 is a structural diagram showing a region of a light-emitting substrate that is covered by red ink after performing a reliability test on the light-emitting substrate under a high temperature and high humidity, in accordance with some embodiments;
FIG. 16 is a partial enlarged view of the region S in FIG. 9; and
FIG. 17 is a sectional view of a light-emitting substrate, in accordance with some embodiments.

## DETAILED DESCRIPTION

The technical solutions in some embodiments of the present disclosure will be clearly and completely described below with reference to the accompanying drawings. Obviously, the embodiments to be described are merely some but not all embodiments of the present disclosure. All other embodiments obtained by a person of ordinary skill in the art based on embodiments of the present disclosure should be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "including, but not limited to". In the description of the specification, the term such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics described herein may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, a feature defined with "first" or "second" may explicitly or implicitly include one or more of the feature. In the description of the embodiments of the present disclosure, the term "a/the plurality of" means two or more unless otherwise specified.

Some embodiments may be described using the term "connected" and derivatives thereof. The term "connected" should be understood in a broad sense; for example, the term "connected" may represent a fixed connection, or a detachable connection, or a one-piece connection; alternatively, the term "connected" may represent a direct connection, or an indirect connection through an intermediate medium. The embodiments disclosed herein are not necessarily limited to the context herein.

The phrase "at least one of A, B and C" has the same meaning as the phrase "at least one of A, B or C", both including following combinations of A, B and C: only A, only B, only C, a combination of A and B, a combination of A and C, a combination of B and C, and a combination of A, B and C.

The phrase "A and/or B" includes following three combinations: only A, only B, and a combination of A and B.

As used herein, the term "if", depending on the context, is optionally construed as "when" or "in a case where".

In addition, the use of the phase "based on" is meant to be open and inclusive, since a process, step, calculation or other action that is "based on" one or more of the stated conditions or values may, in practice, be based on additional conditions or value exceeding those stated.

The term such as "about", "substantially" or "approximately" as used herein includes a stated value and an average value within an acceptable range of deviation of a particular value; the acceptable range of deviation may be determined, for example, by a person of ordinary skill in the art, considering measurement in question and errors (i.e., limitations of a measurement system) associated with measurement of a particular quantity.

The term such as "parallel", "perpendicular" or "equal" as used herein includes a stated condition and a condition similar to the stated condition within an acceptable range of deviation; the acceptable range of deviation may be determined, for example, by a person of ordinary skill in the art, considering measurement in question and errors (i.e., limitations of a measurement system) associated with measurement of a particular quantity. For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°; and the term "equal" includes absolute equality and approximate equality, and an acceptable range of deviation of the approximate equality may be, for example, that a difference between two equals is less than or equal to 5% of either of the two equals.

It will be understood that, in a case where a layer or element is referred to as being on another layer or substrate, it may be that the layer or element is directly on the another layer or substrate, or it may be that intermediate layer(s) exist between the layer or element and the another layer or substrate.

Exemplary embodiments are described herein with reference to sectional views and/or plan views as idealized exemplary drawings. In the accompanying drawings, thicknesses of layers and sizes of regions are enlarged for clarity. Thus, variations in shape with respect to the accompanying drawings due to, for example, manufacturing technologies and/or tolerances may be envisaged. Therefore, the exemplary embodiments should not be construed as being limited to the shapes of the regions shown herein, but including shape deviations due to, for example, manufacturing. For example, an etched region shown to have a rectangular shape generally has a feature of being curved. Therefore, the regions shown in the accompanying drawings are schematic in nature, and their shapes are not intended to show actual shapes of the regions in an apparatus, and are not intended to limit the scope of the exemplary embodiments.

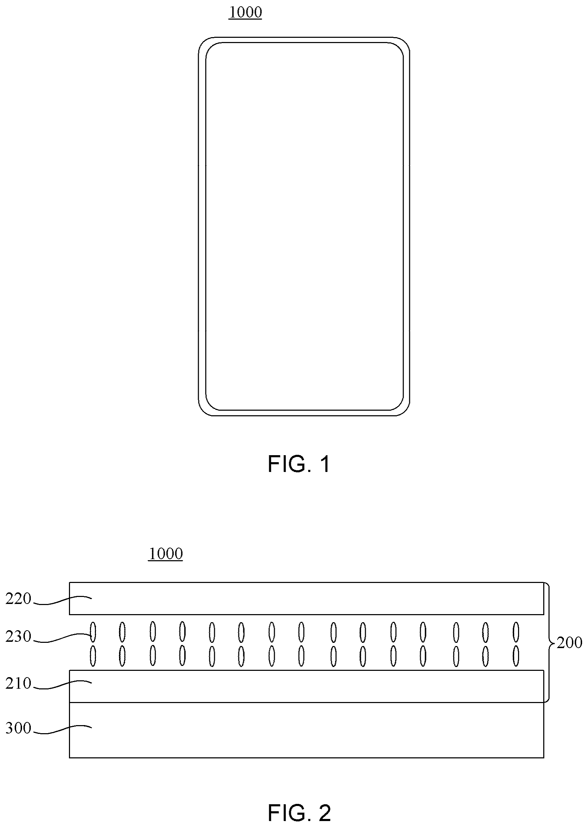

FIG. 1 is a top view of a display apparatus, in accordance with some embodiments.

As shown in FIG. 1, some embodiments of the present disclosure provide a display apparatus 1000.

For example, the display apparatus 1000 may be any display apparatus that displays images whether in motion (e.g., a video) or stationary (e.g., static images), and whether textual or graphical. More specifically, it is expected that the display apparatus of the embodiments may be implemented in or associated with a variety of electronic devices. The variety of electronic devices may include (but are not limit to), for example, mobile phones, wireless devices, personal data assistants (PDA), handheld or portable computers, GPS receivers/navigators, cameras, MP4 video players, video cameras, game consoles, watches, clocks, calculators, TV monitors, flat panel displays, computer monitors, car displays (e.g., odometer displays), navigators, cockpit controllers and/or displays, camera view displays (e.g., rear view camera displays in vehicles), electronic photos, electronic billboards or indicators, projectors, building structures, packagings and aesthetic structures (e.g., a display for an image of a piece of jewelry), etc.

For example, the display apparatus 1000 may be any one of a liquid crystal display (LCD) apparatus, a mini light-emitting diode (mini LED) display apparatus, and a micro light-emitting diode (micro LED) display apparatus.

FIG. 2 is a structural diagram of a display apparatus, in accordance with some embodiments.

As shown in FIG. 2, in a case where the display apparatus 1000 is a liquid crystal display apparatus, the display apparatus 1000 includes a backlight module 300 and a liquid crystal display panel 200. The liquid crystal display panel 200 is located on a light exit side of the backlight module 300, and the backlight module 300 is configured to provide a light source for the liquid crystal display panel 200, so that the liquid crystal display panel 200 may display images.

The structure of the liquid crystal display panel 200 mainly includes an array substrate 210, an opposite substrate 220, and a liquid crystal layer 230 disposed between the array substrate 210 and the opposite substrate 220.

In some examples, the opposite substrate 220 may be a color filter (CF) substrate.

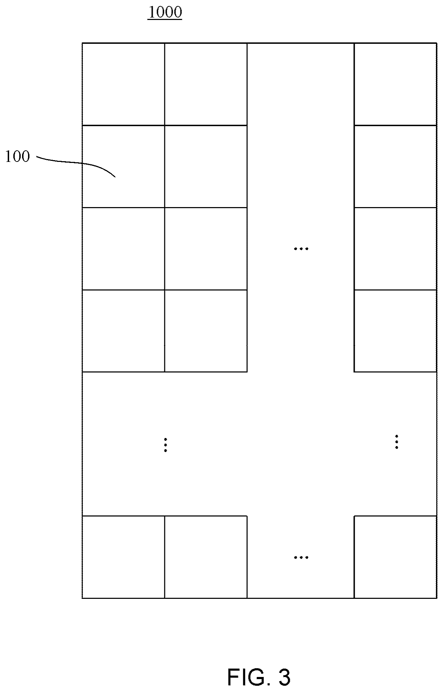

In some embodiments, as shown in FIG. 3, the backlight module 300 includes a light-emitting substrate 100. The light-emitting substrate 100 is configured to provide light for the liquid crystal display panel, so that the liquid crystal display panel may display images.

It will be understood that, light can be emitted by the light-emitting substrate 100 of the backlight module 300 and enter the liquid crystal layer 230. The intensity of light passing through the liquid crystal layer 230 can be adjusted by adjusting the arrangement of liquid crystal molecules in the liquid crystal layer 230, so that the intensity of light incident on the opposite substrate 220 may be adjusted. The opposite substrate 220 may be a color filter substrate, so that the display apparatus 1000 can achieve a function of displaying color images by adjusting the intensity of light incident on different color resist units.

In some examples, the light-emitting substrate 100 includes a plurality of light-emitting chips, and the plurality of light-emitting chips are all configured to emit white light.

It will be understood that, local dimming in a small range may be achieved by closely arranging a large number of light-emitting chips in the backlight module 300, so that the backlight module 300 may have good brightness uniformity and high color contrast within a small color-mixing distance, which facilitates ultra-thin, high color rendering and energy-saving characteristics of a terminal product equipped with the backlight module 300.

In some examples, the backlight module of the display apparatus 1000 may further include an optical film, and the optical film is located on a side of the light-emitting substrate 100 proximate to the liquid crystal display panel. The optical film may include a reflective sheet, a diffusion plate, a brightness enhancement film (a prism sheet), or a diffusion sheet, which may be used to increase the brightness and improve the uniformity of light.

FIG. 3 is a structural diagram of a display apparatus, in accordance with some other embodiments.

As shown in FIG. 3, in a case where the display apparatus 1000 is a mini LED display apparatus or a micro LED display apparatus, the display apparatus 1000 includes a display panel, and the display panel includes at least one light-emitting substrate 100.

The difference between the display apparatus 1000 shown in FIG. 3 and the display apparatus 1000 shown in FIG. 2 is that, there is no need to provide a backlight module for the display apparatus 1000 shown in FIG. 3, and it is possible to directly use the light-emitting substrate(s) 100 in the display panel to directly display images.

In some examples, the display apparatus 1000 may include a plurality of light-emitting substrates 100, and the plurality of light-emitting substrates 100 are tiled together to constitute the display apparatus 1000. Alternatively, the display apparatus 1000 may include one light-emitting substrate 100. FIG. 3 is illustrated with an example in which the display apparatus 1000 includes a plurality of light-emitting substrates 100.

In some examples, the light-emitting substrate 100 includes a plurality of light-emitting chips, and the plurality of light-emitting chips are configured to emit red light, green light and blue light, so that the display apparatus 1000 can achieve color display.

In some examples, the display apparatus 1000 may further include an antireflection film and a protective cover. The antireflection film is located between the light-emitting substrate 100 and the protective cover. The antireflection film includes a polarizer, and the polarizer may be a circular polarizer. Here, the polarizer may reduce reflection of external light, so as to avoid glaring due to the reflection of the ambient light on the light-emitting substrate 100.

In some embodiments, the display apparatus 1000 may adopt a chips-on-board (COB) technology to further reduce the spacing between the light-emitting chips in the light-emitting substrate 100 to improve the resolution of the display apparatus 1000, thereby improving the visual effect of the display apparatus 1000 and reducing the thickness of the display apparatus 1000 to improve the applicability of the display apparatus 1000.

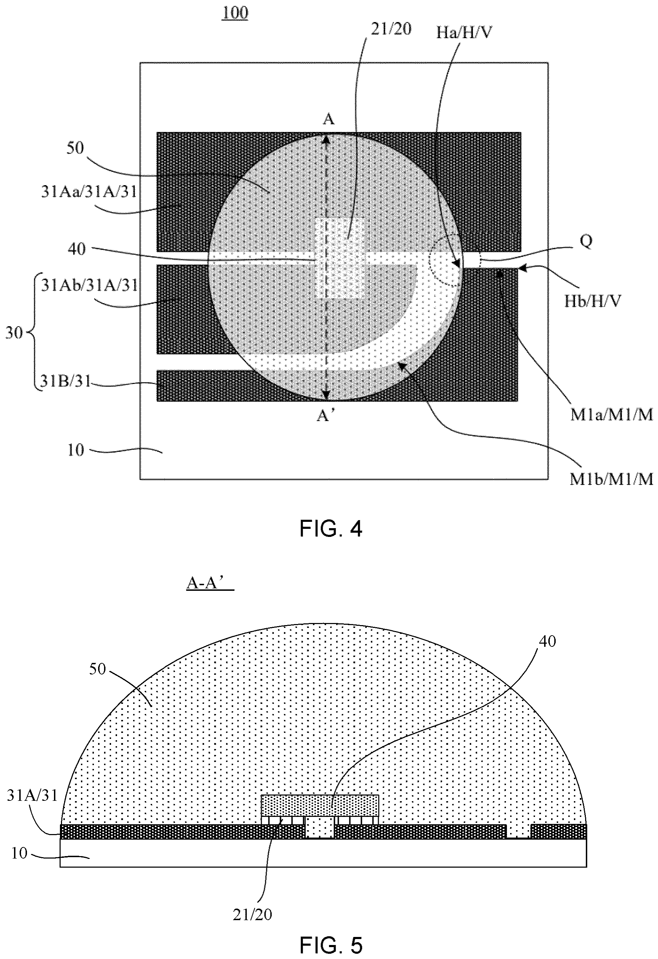

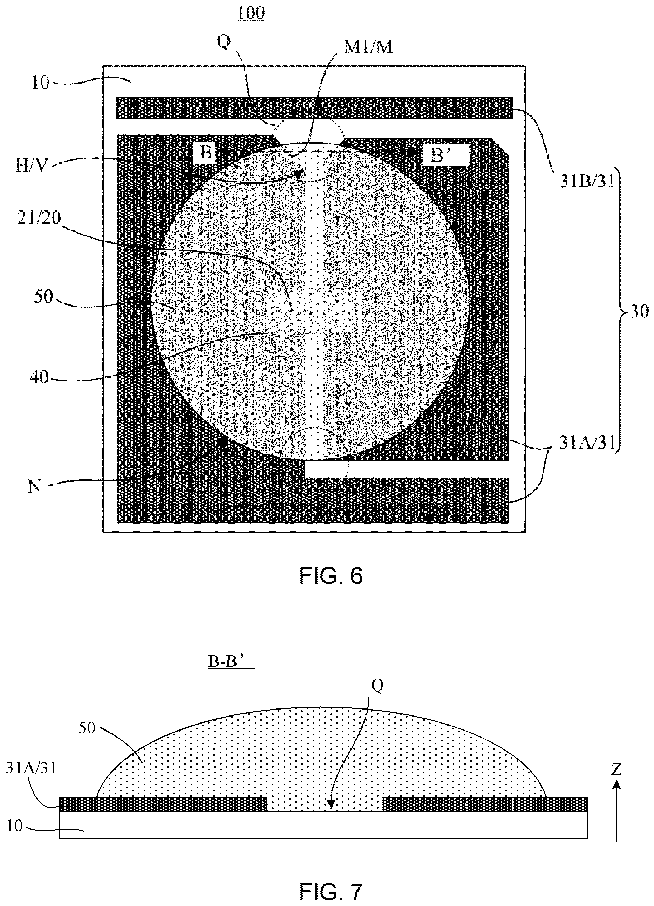

FIG. 4 is a partial structural diagram of a light-emitting substrate, in accordance with some possible implementations; FIG. 5 is a sectional view taken along the line A-A' in FIG. 4; FIG. 6 is a partial structural diagram of a light-emitting substrate, in accordance with some other possible implementations; and FIG. 7 is a sectional view taken along the line B-B' in FIG. 6.

Referring to FIGS. 4 to 7, some embodiments of the present disclosure provide a light-emitting substrate 100. The light-emitting substrate 100 includes a substrate 10, and a plurality of pad groups 20, a plurality of signal line groups 30, and a plurality of light-emitting chips 40 that are located on the substrate 10. A pad group 20 includes two pads 21.

In some examples, the substrate 10 may be an aluminum substrate. The substrate 10 of the light-emitting substrate 100 is an aluminum substrate, which may meet the requirement for the flexibility of the light-emitting substrate 100, so that the display apparatus 1000 may achieve curved display. As a result, the applicability of the display apparatus 1000 is further improved. Furthermore, the requirement for heat dissipation of the light-emitting substrate 100 of the display apparatus 1000 may also be met.

In some examples, the light-emitting chip 40 may be a micro light-emitting diode (micro LED) or a mini light-emitting diode (mini LED). In comparison with a light source that adopts conventional LEDs, more precise dynamic contrast control may be achieved with a light source adopting the micro LED or the mini LED, thereby improving the dynamic contrast of the display apparatus 1000.

In some examples, in a direction away from the substrate 10, the light-emitting chip 40 may include: a first pin, a first semiconductor layer electrically connected to the first pin, a light generating layer, a second semiconductor layer, and a second pin electrically connected to the second semiconductor layer. The second pin is located between the second semiconductor layer and the substrate 10. That is, the light-emitting chip 40 may be a flip-chip LED.

In a case where different voltages are respectively applied to the first pin and the second pin to create an electric field between the two, a PN junction with a potential barrier may be formed between the first semiconductor layer and the second semiconductor layer; carriers in the first semiconductor layer and carriers in the second semiconductor layer will enter the light generating layer and recombine, and excess energy will be released in a form of light, so that electric energy is directly converted into light energy to make the light-emitting chip 40 emit light.

In some examples, the first semiconductor layer may be made of one of an N-type semiconductor and a P-type semiconductor, and the second semiconductor layer 224 may be made of the other of the N-type semiconductor and the P-type semiconductor.

In some examples, the first pin electrically connected to the first semiconductor layer may be an anode of the light-emitting chip 40, and the second pin electrically connected to the second semiconductor layer may be a cathode of the light-emitting chip 40, and some embodiments of the present disclosure are not limited thereto.

In some examples, the light generating layer may be a multiple quantum well (MQW) layer.

In the case where the display apparatus 1000 is a liquid crystal display apparatus, the light-emitting substrate 100 serves as a backlight source of the display apparatus 1000 and is configured to provide a light source for the liquid crystal display apparatus. Each light-emitting chip 40 may be controlled separately; thus, the display apparatus may achieve local dimming and a high-dynamic range (HDR) image effect, thereby improving the display quality of the display apparatus 1000.

In the case where the display apparatus 1000 is a mini LED display apparatus or a micro LED display apparatus, the plurality of light-emitting chips 40 (e.g., micro LEDs or mini LEDs) in the light-emitting substrate 100 emit light to directly display images.

For example, the plurality of light-emitting chips 40 may be light-emitting elements capable of emitting light of a same color, such as any one of blue LED, red LED, green LED or yellow LED. In this case, the display apparatus 1000 may be a single-color display apparatus, such as an instrument dial, a signal indicator screen, or the like.

For another example, the plurality of light-emitting chips 40 may include light-emitting elements of multiple different colors, such as at least two of red LED, green LED, blue LED or yellow LED, and light-emitting chips 40 of different colors may be separately controlled. In this way, the display apparatus 1000 may perform color display by light-mixing.

In some examples, the plurality of light-emitting chips 40 in the light-emitting substrate 100 are arranged in multiple rows and multiple columns. For convenience of description, the plurality of light-emitting chips 40 are described in the present disclosure by taking an example in which the plurality of light-emitting chips 40 are arranged in a matrix.

As shown in FIGS. 4 and 6, the light-emitting substrate 100 may include the plurality of signal line groups 30 formed on the substrate 10, and a signal line group 30 may be correspondingly connected to a light-emitting chip 40 through a pad group 20. Each signal line group 30 may include at least two signal lines 31, and any adjacent signal lines 31 have a gap therebetween, so as to avoid the problem of short circuit. The light-emitting substrate 100 may use the signal lines of the signal line group 30 to transmit a driving signal to the light-emitting chip 40 through the pads 21, so that the light-emitting chip 40 emits light.

In some examples, in a case where the signal line group 30 includes two signal lines 31, the two signal lines 31 are two signal lines 31 respectively connected to two pads 21 of the pad group 20. That is, the two signal lines 31 are electrically connected to two pins of the light-emitting chip 40 through the two pads, respectively. For example, one of the two signal lines 31 is connected to one pin of the light-emitting chip 40 through one pad 21 of the pad group 20, and the other signal line 31 is electrically connected to the other pin of the light-emitting chip 40 through the other pad 21 of the pad group 20, so as to realize the electrical connection between the signal line group 30 and the light-emitting chip 40.

In some other examples, in a case where each signal line group 30 includes at least three signal lines 31, the signal lines 31 of the signal line group 30 are divided into two types of signal lines 31, which are first-type signal lines 31A and second-type signal line(s) 31B. The first-type signal lines 31A are the two signal lines 31 respectively connected to the two pads 21 of the pad group 20. The second-type signal line 31B is a signal line 31 in the same signal line group 30 except for the first-type signal lines 31A.

It will be noted that the type and number of the second-type signal lines 31B are not limited in the present disclosure. The second-type signal line 31B may be a signal line 31 surrounding the corresponding light-emitting chip 40 and connected to other light-emitting chips 40.

In some examples, the light-emitting chip 40 may be fixedly connected to the pads 21 and the signal lines 31 on the substrate 10 by adopting a chip-on-board (COB, in which an integrated circuit (IC) bare chip is fixed onto a printed circuit board by bonding) technology.

Based on this, the width, length, and thickness of the signal line 31 in the light-emitting substrate 100 will affect the upper limit of the maximum current that the corresponding signal line 31 can carry. The signal line 31 in the currently developed light-emitting substrate 100 needs to flow a relatively high current. Therefore, the signal line 31 in the light-emitting substrate 100 needs to be widened and thickened to increase the area of the cross-section of the signal line 31 in a plane perpendicular to the substrate 10, so as to reduce the impedance of the signal line 31 such that the signal line 31 can carry a high current to meet the requirement of the light-emitting substrate 100 for current.

In some embodiments, a thickness of the signal line 31 is greater than or equal to 20 $\mu$m. In this way, the thickness of the signal line 31 is great, which helps to reduce the impedance of the signal line. Furthermore, the signal line 31 having a great thickness may also increase the heat dissipation area of the signal line 31 to a certain extent, thereby improving the heat dissipation effect of the signal line 31.

In some examples, the thickness of the signal line 31 is in a range of approximately 20 $\mu$m to 35 $\mu$m, inclusive.

In a case where the thickness of the signal line 31 is equal to or close to 20 $\mu$m, the signal line 31 may have a good heat dissipation effect and carry a high current. Furthermore, it is also possible to prevent from affecting the lightness and thinness of the light-emitting substrate 100 caused by a case that the signal line 31 is too thick and.

In a case where the thickness of the signal line 31 is equal to or close to 35 $\mu$m, the signal line 31 may have a good heat dissipation effect and carry a high current while the requirement for the lightness and thinness of the light-emitting substrate 100 is met.

For example, the thickness of the signal line may be any one of 20 $\mu$m, 22 $\mu$m, 25 $\mu$m, 28 $\mu$m, 30 $\mu$m, or 35 $\mu$m, and the embodiments of the present disclosure are not limited thereto.

For example, the thickness of the signal line 31 is about 30 $\mu$m. In this case, the signal line 31 has a good heat dissipation effect and may carry a high current to meet the requirements of the light-emitting substrate 100.

It will be noted that, due to the existence of certain uncontrollable errors (e.g., manufacturing process errors, equipment precision, or measurement errors), the case that the thickness of the signal line 31 fluctuates within a range of 10% $\times$ 30 $\mu$m may also be considered as that the thickness of the signal line 31 is equal to 30 $\mu$m.

Since the light-emitting chip 40 is directly bonded to the substrate in the COB solution, the problem of poor water and oxygen resistance of the light-emitting chip 40 should be considered during the application process. Therefore, referring to FIGS. 4 to 7, the light-emitting substrate 100 in the embodiments may further include a protective structure 50. The protective structure 50 is located on a side of the light-emitting chip 40 away from the substrate 10, and an orthographic projection of the light-emitting chip 40 on the substrate 10 is located inside of a border of an orthographic projection of the protective structure 50 on the substrate 10.

With such an arrangement, the protective structure 50 may be used to cover the light-emitting chip 40, and the protective structure 50 may play a role of protecting the light-emitting chip 40 to alleviate the problem that external water vapor may be in contact with the light-emitting chip 40, thereby alleviating the problem of poor water and oxygen resistance of the light-emitting chip 40 to prolong the service life of the light-emitting chip 40.

In some embodiments, as shown in FIG. 5, a contour of a cross-section of the protective structure 50 along the plane perpendicular to the substrate 10 protrudes toward a direction away from the substrate.

With this design, the protective structure 50 may not only cover the light-emitting chip 40 to play the role of protecting the light-emitting chip 40, but also serve as a lens. In this way, the protective structure 50 is disposed on the side of the light-emitting chip 40 away from the substrate 10, so that the protective structure 50 may be used to increase the light exit angle of the light-emitting chip 4 to improve the light efficiency of the light-emitting substrate 100 and improve the brightness uniformity of the light-emitting substrate 100.

In some examples, the cross-section of the protective structure 50 along the plane perpendicular to the substrate 10 may be in a shape of a semicircle. With this design, the protective structure 50 may be used not only to protect the light-emitting chip 40, but also to increase the light exit angle of the light-emitting chip 40 to improve the brightness uniformity of the light-emitting substrate 100.

In some examples, the protective structure 50 may be a protective adhesive. For example, the protective adhesive may be silicone-based adhesive. In actual manufacturing processes, it is possible to adopt an encapsulation method in which a coating process is performed with the protective adhesive in dots to save material and reduce cost, and the embodiments of the present disclosure are not limited thereto.

In some embodiments, as shown in FIGS. 6 and 7, a maximum span of a second contour N corresponding to the protective structure 50 may be in a range of 4.46 mm to 4.66 mm, inclusive. The maximum span of the second contour N may be understood as an equivalent diameter of the second contour N. The "equivalent diameter" is a diameter of a circle having the same area as the second contour.

In the case where the maximum span of the second contour N corresponding to the protective structure 50 is in the range of 4.46 mm to 4.66 mm, not only the requirements for precision of relevant manufacturing processes are met, but also the orthographic projection of the light-emitting chip 40 on the substrate 10 is located inside of the border of the orthographic projection of the protective structure 50 on the substrate 10 to protect the light-emitting chip 40. Furthermore, a problem of cracking easily occurring in the protective structure 50 due to a large maximum span of the second contour N corresponding to the protective structure 50 may be avoided.

For example, the maximum span of the second contour N corresponding to the protective structure 50 is any one of approximately 4.46 mm, 4.5 mm, 4.56 mm, 4.6 mm or 4.66 mm, and the embodiments of the present disclosure are not limited thereto.

For example, the maximum span of the second contour N corresponding to the protective structure 50 is approximately 4.56 mm, and in this case, the protective structure 50 may not only protect the light-emitting chip 40, but also meet the requirements of existing processes and reduce the problem of cracking in the protective structure 50.

It will be noted that, due to the existence of certain uncontrollable errors (e.g., manufacturing process errors, equipment precision, or measurement errors), the case that the maximum span of the second contour N corresponding to the protective structure 50 fluctuates within a range of 4.56 mm ± 0.1 mm may also be considered as that the maximum span of the second contour N corresponding to the protective structure 50 is equal to 4.56 mm.

In some examples, in a case where the second contour N of the orthographic projection of the protective structure 50 on the substrate 10 is in a shape of circle, the maximum span of the second contour N corresponding to the protective structure 50 may be the diameter of the second contour N, and the embodiments of the present disclosure are not limited thereto. For example, the second contour N of the orthographic projection of the protective structure 50 on the substrate 10 may be in other shapes, such as an ellipse.

In some embodiments, as shown in FIGS. 6 and 7, in a thickness direction Z of the substrate 10, a height of the protective structure 50 is in a range of 1.4 mm to 1.55 mm. In the thickness direction Z of the substrate 10, the height of the protective structure 50 may be a distance between a surface of the protective structure 50 proximate to the substrate 10 and a highest point of a surface of the protective structure 50 away from the substrate 10.

The height of the protective structure 50 is in the range of 1.4 mm to 1.55 mm, so that the protective structure 50 may well increase the light exit angle of the light-emitting chip 40 covered by the orthographic projection of the protective structure 50, and it is possible to facilitate the improvement the brightness uniformity of the light-emitting substrate 100.

For example, the height of the protective structure 50 is any one of approximately 1.4 mm, 1.41 mm, 1.45 mm, 1.48 mm, 1.5 mm, or 1.55 mm.

For example, the height of the protective structure 50 is approximately 1.48 mm. In this case, the protective structure 50 may not only protect the light-emitting chip 40, but also serve as a lens to improve the brightness uniformity of the light-emitting substrate 100.

It will be noted that, due to the existence of certain uncontrollable errors (e.g., manufacturing process errors, equipment precision, or measurement errors), the height of the protective structure 50 fluctuates within a range of 1.48 ± 0.07 mm, which may also be considered as that the height of the protective structure 50 is equal to 1.48 mm.

In some examples, in the case where the cross-section of the protective structure 50 along the plane perpendicular to the substrate 10 is in a shape of a semicircle, the height of the protective structure 50 may be the radius of the semicircle, and the embodiments of the present disclosure are not limited thereto. The second contour N of the orthographic projection of the protective structure 50 on the substrate 10 may also be in other shapes, such as a semi-ellipse.

In the above embodiments, the thickness of the signal line 31, and the shape, maximum span and height of the protective structure 50 are described in conjunction with relevant drawings. However, the inventors have found through researches that, on the basis that the light-emitting substrate 100 is provided with a plurality of light-emitting chips 40 and a plurality of pad groups 20 and signal line groups 30 and other devices corresponding thereto, a protective structure 50 is provided to protect the light-emitting chip 40. In this case, the protective structure 50 is prone to cracking and thus fails to effectively block water vapor and protect the light-emitting chip 40 well.

Specifically, since the light-emitting substrate 100 is provided with the plurality of light-emitting chips 40, and the plurality of pad groups 20 and signal line groups 30 and other devices corresponding thereto, the signal lines 31 in the light-emitting substrate 100 need to be arranged for avoidance. That is, the two signal lines 31 of the signal line group 30 connected to the two pins of the light-emitting chip 40 may need to be arranged for avoidance to prevent the two signal lines 31 connected to the two pads 21 from affecting the arrangement of other devices such as the light-emitting chips 40.

For example, an orthographic projection of any signal line 31 of the signal line group 30 on the substrate 10 has a first contour M, the first contour M includes a plurality of edges M1 that are sequentially connected, each edge M1 is a line without a corner point, any two connected edges M1 have an intersection **H,** and extension directions of the two edges M1 at the intersection H have an angle. It may be understood as that any two connected edges M1 intersect and are connected at the intersection H to form a corner V of the signal line 31.

Based on this, by adjusting to the angle formed between any two connected edges M1, it is possible to adjust the extent of bending of the corresponding signal line 31, so that the signal line 31 may avoid other devices in the light-emitting substrate 100 to alleviate the problem of short circuit of the signal line 31.

It will be noted that the edge M1 of the first contour M may be a straight edge or a curved edge. As shown in FIG. 4, the upper rectangular first-type signal line 31A is defined as a first first-type signal line 31Aa, and the first first-type signal line 31Aa is equivalent to including four edges M1 that are connected end to end. In addition, the four edges M1 of the first first-type signal line 31Aa are all straight edges. The lower first-type signal line 31A is defined as a second first-type signal line 31Ab, and the second first-type signal line 31Ab is equivalent to including three edges M1 that are connected end to end. The three edges M1 of the second first-type signal line 31Ab include two straight edges and one curved edge. An angle between a curved edge and a straight edge may be an angle between a tangent of the curved edge and the straight edge. The lower second-type signal line 31B is equivalent to including five edges M1 that are connected end to end. The five edges M1 of the second-type signal line 31B include four straight edges and one curved edge.

As shown in FIGS. 4 and 6, the orthographic projection of the protective structure 50 on the substrate 10 has a second contour N. In order to ensure that the protective structure 50 completely cover the light-emitting chip 40, the orthographic projection of the protective structure 50 on the substrate 10 overlaps with an orthographic projection of a portion of the signal line 31 that is connected to the light-emitting chip 40 on the substrate 10. That is, an orthographic projection of the signal line 31 on the substrate 10 overlaps with the second contour N. However, after the signal line 31 is arranged for avoidance, an orthographic projection of the corner V of the signal line 31 on the substrate 10 may overlap with the second contour N. That is, at least one intersection H in a plurality of intersection H of the first contour M overlaps with the second contour N.

However, since there is a gap between any two adjacent signal lines 31, and the signal line 31 has a great thickness, a groove with a great depth is formed between any two adjacent signal lines 31 and the gap therebetween. At the corner V (the intersection H) of one of the any two adjacent signal lines 31, the extension direction of the border of the signal line 31 will change, so that the distance between the signal line 31 and another signal line 31 adjacent thereto at the corner V (the intersection H) of the signal line 31 will be increased, which is equivalent to increasing the width of the groove Q formed by the two signal lines 31 and the gap between the two signal lines 31.

Specifically, as shown in FIG. 4, the description will be made by taking an example in which the two adjacent signal lines 31 are a first first-type signal line 31Aa and a lower second-type signal line 31B, respectively. The second-type signal line 31B includes a first edge M1a proximate to the first first-type signal line 31Aa, and a second edge M1b connected to the first edge M1a and adjacent to a second first-type signal line 31Ab. The first edge M1a and the second edge M1b of the second-type signal line 31B intersect at a first intersection Ha.

The second edge M1b of the second-type signal line 31B is equivalent to that the second-type signal line 31B is bent toward a side away from the first first-type signal line 31Aa. Therefore, the gap between the second-type signal line 31B and the first first-type signal line 31Aa will change starting from the position of the first intersection Ha of the second-type signal line 31B. That is, the space (distance) between the first first-type signal line 31Aa and the second-type signal line 31B at the position where the extension direction of the second-type signal line 31B changes is increased. On this basis, the width of the groove formed by the second edge M1b of the second-type signal line 31B, the first first-type signal line 31Aa and the space between the two is relatively great. That is, a width of a first groove formed by the second edge M1b of the second-type signal line 31B, the first first-type signal line 31Aa and the space between the two is greater than a width of a second groove formed by the first edge M1a of the second-type signal line 31B, the first first-type signal line 31Aa and the space between the two.

In the above structure, in a case where other film layers are provided between the protective structure 50 and the signal line group 30, the first groove and the second groove may be filled with other film layers between the protective structure 50 and the signal line group 30. Since the width of the second groove is relatively small, the second groove is substantially fully filled with the other film layers between the protective structure 50 and the signal line group 30, or the bottom of the second groove is significantly raised, so as to reduce the depth of the second groove. However, since the width of the first groove is relatively great, the groove cannot be fully filled with the other film layers between the protective structure 50 and the signal line group 30. That is, the depth of the first groove is still relatively great. For example, other film layers between the protective structure 50 and the signal line group 30 may be a reflective layer. The reflective layer will be described in detail below and will not be elaborated here.

On this basis, in a case where a border (the second contour N) of the orthographic projection of the protective structure 50 on the substrate 10 overlaps with the first intersection Ha of the second-type signal line 31B, the border of the protective structure 50 will be at a position where the extension direction of the contour of the second-type signal line 31B is changed. As a result, in terms of the protective structure 50, at this position, a border of the protective structure 50 is likely to shrink inward or expand outward to the position where the extension direction of the second-type signal line 31B is changed. That is, the border (the second contour N) of the orthographic projection of the protective structure 50 on the substrate 10 will be located in the first groove formed by the second edge M1b of the second-type signal line 31B, the first first-type signal line 31Aa and the space between the two.

Therefore, the border of the protective structure 50 passes through a stair with a large height difference formed by the second edge M1b of the second-type signal line 31B and the substrate 10, and the border of the protective structure 50 also passes through a stair formed by the first first-type signal line 31Aa and the substrate 10. However, since the height difference between the signal line 31 and the substrate 10 is relatively large, the protective structure 50 formed at the position with the height difference may be easily cracked due to its own stress. That is, the protective structure 50 is prone to cracking at the position with a height difference formed at the corner V (the intersection H) of the signal line 31. At the position where the protective structure 50 is cracked, the water-oxygen resistance of the protective structure 50 is reduced.

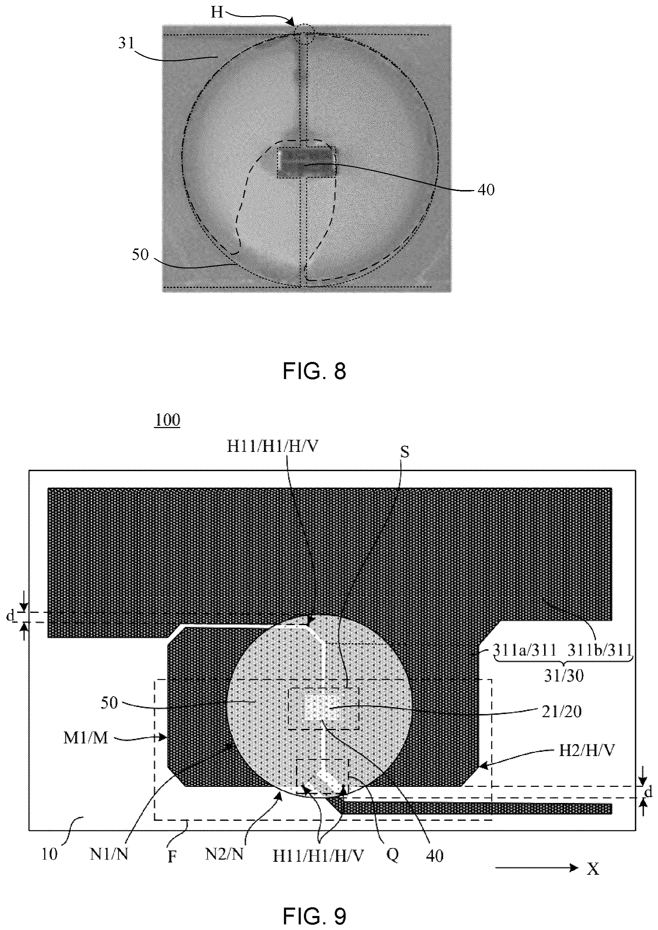

FIG. 8 is a structural diagram showing a region of a light-emitting substrate that is covered by red ink after performing a reliability test on the light-emitting substrate under a high temperature and high humidity, in accordance with some possible implementations.

Since the border (the second contour N) of the orthographic projection of the protective structure 50 on the substrate 10 overlaps with the corner V (the intersection H) of the signal line 31, cracking will appear at a position of the protective structure 50, which corresponds to the second contour N corresponding to the corner V (the intersection H) of the signal line 31.

On this basis, after performing a reliability test on the light-emitting substrate 100 under a high temperature and high humidity for about 12 hours, as shown in FIG. 8, a large amount of red ink will gradually enter the region (the region of red ink entering the protective structure 50 is the region indicated by the dotted closed line in FIG. 8) covered by the protective structure 50 from the cracking at the position of the protective structure 50, which corresponds to the second contour N corresponding to the corner V (the intersection H) of the signal line 31. As a result, the light-emitting chip 40 covered by the protective structure 50 will still be corroded by the red ink, which affects the service life of the light-emitting chip 40.

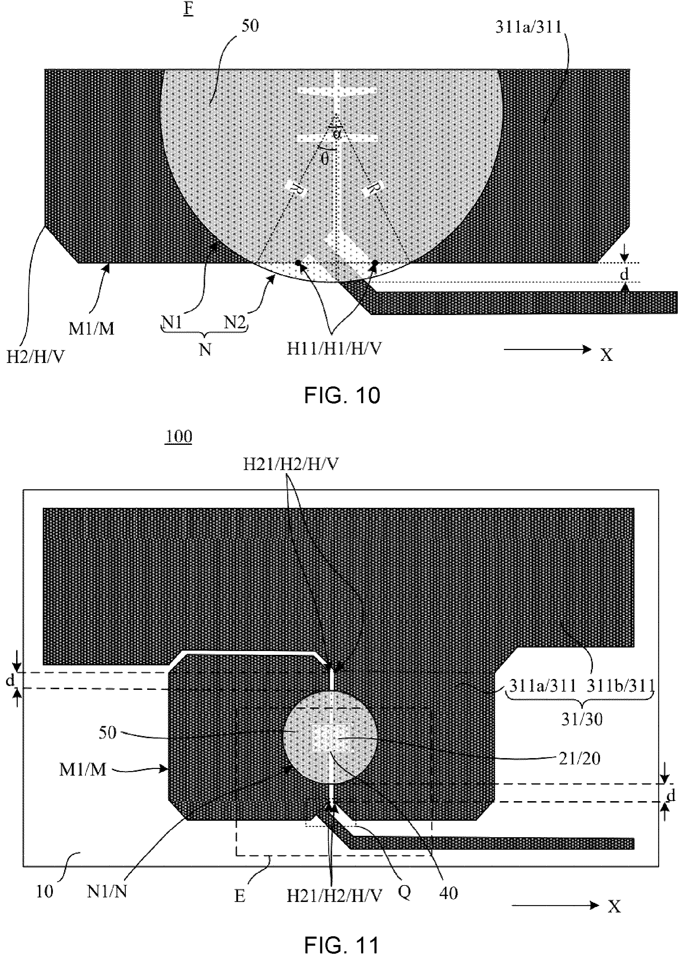

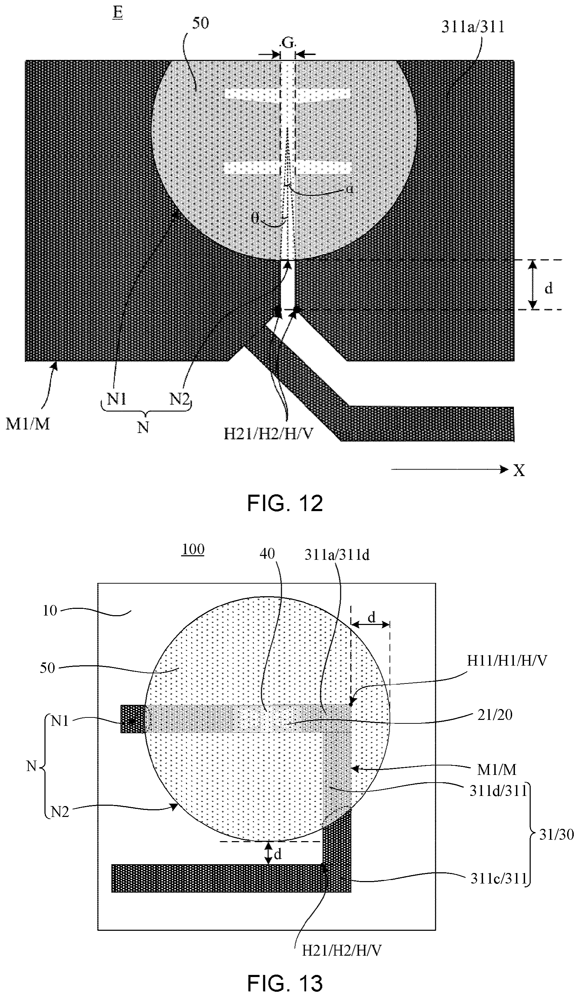

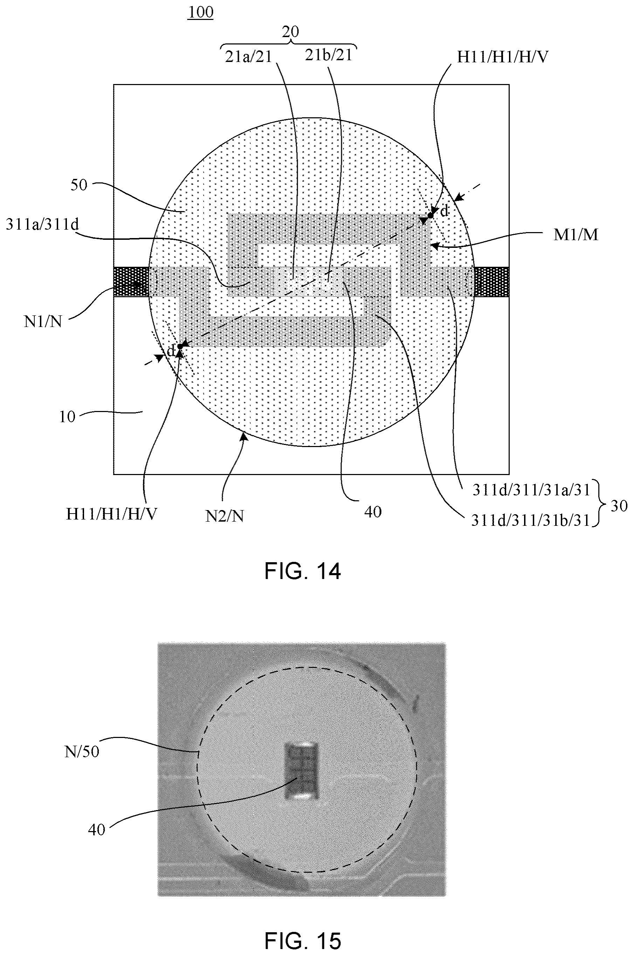

FIG. 9 is a partial structural diagram of a light-emitting substrate, in accordance with some embodiments; FIG. 10 is a partial enlarged view of the region F in FIG. 9; FIG. 11 is a partial structural diagram of a light-emitting substrate, in accordance with some other embodiments; FIG. 12 is a partial enlarged view of the region E in FIG. 11; FIG. 13 is a partial structural diagram of a light-emitting substrate, in accordance with still some other embodiments; and FIG. 14 is a partial structural diagram of a light-emitting substrate, in accordance with yet still some other embodiments.

Based on this, as shown in FIGS. 9 to 14, the light-emitting substrate 100 provided in the embodiments of the present disclosure further includes a protective structure 50, the protective structure 50 is located on a side of the light-emitting chip 40 away from the substrate 10, and an orthographic projection of the protective structure 50 on the substrate 10 has a second contour N. The orthographic projection of the light-emitting chip 40 on the substrate 10 is disposed inside of the border (the second contour N) of the orthographic projection of the protective structure 50 on the substrate 10. In addition, an intersection H where any two connected edges M1 of a first contour M corresponding to any signal line 31 intersect with each other is arranged to have a safe distance from the second contour N corresponding to the protective structure 50.

The "safe distance" is a minimum distance between the intersection H and the second contour N after taking the process errors that may occur during the manufacturing process of the light-emitting substrate 100 into consideration. That is, in the case where the intersection H where any two connected edges M1 of a first contour M corresponding to any signal line 31 intersect with each other is arranged to have a safe distance from the second contour N corresponding to the protective structure 50, even if there is a process error in the manufacturing process of the light-emitting substrate 100, the intersection H where any two connected edges M1 of the first contour M corresponding to any signal line 31 intersect with each other is arranged to have a distance from the second contour N corresponding to the protective structure 50, thereby avoiding a situation where the intersection H of the signal line 31 overlaps with the second contour N corresponding to the protective structure 50.

With the arrangement, the border (the second contour N) of the protective structure 50 and the intersection H of the first contour M of any signal line 31 may have a reserved space therebetween, so that the intersection H of the signal line 31 avoids the second contour N corresponding to the protective structure 50 to prevent the border (the second contour N) of the protective structure 50 from being stuck at the position of the corner V of the signal line 31. As a result, the probability of the border of the protective structure 50 being located at an uneven position is reduced, and the probability of cracking appearing in the protective structure 50 is reduced, thereby ensuring the water-oxygen resistance of the protective structure 50 to increase the service life of the light-emitting chip 40.

In some examples, as shown in FIGS. 9 and 10, the plurality of intersections H include a plurality of first intersections H1. An orthographic projection of a first intersection H1 on the substrate 10 is located inside of the second contour N. That is, the orthographic projection of the protective structure 50 on the substrate 10 covers the orthographic projection of the first intersection H1 of the signal line 31 on the substrate 10.

In this case, the plurality of first intersections H1 include at least one target first intersection H11 having a minimum distance from the second contour N. The first intersection H11 may be arranged to have a safe distance from the second contour N. The target first intersection H11 having the minimum distance from the second contour N is arranged to have a safe distance from the second contour N, which means that any first intersection H1 in the plurality of first intersections H1 has a distance greater than the safe distance from the second contour N.

That is, in the case where the protective structure 50 covers the plurality of first intersections H1 of the signal line 31, the border (the second contour N) of the protective structure 50 may be arranged to have a safe distance from the orthographic projection of the target first intersection H11 that is covered by the protective structure 50 on the substrate 10.

This design is equivalent to adjusting the signal line 31 such that the first intersection H1 that may overlap with the second contour N moves inward. Thus, the target first intersection H11 is ensured to move inwardly to the inside of the second contour N, and the target first intersection H11 is ensured to move inwardly to have a safe distance from the second contour N. That is, each first intersection H1 may have a distance equal to or greater than the safe distance from the second contour N.

Based on this, it is possible to prevent the border (the second contour N) of the protective structure 50 from overlapping with the first intersection H1 of the signal line 31, which may prevent the border (the second contour N) of the protective structure 50 from being located in the groove Q at a position corresponding to the first intersection H1 of the signal line 31, thereby reducing the probability of cracking appearing in the protective structure 50 to increase the service life of the light-emitting chip 40.

In some other examples, as shown in FIGS. 11 and 12, the plurality of intersections H may include a plurality of second intersections H2. An orthographic projection of a second intersection H2 on the substrate 10 is non-overlapping with the orthographic projection of the protective structure 50 on the substrate 10, which may also be understood as that an intersection H located outside of the second contour N in the plurality of intersections H of the signal line 31 is the second intersection H2.

In this case, the plurality of second intersections H2 include at least one target second intersection H21 having a minimum distance from the second contour N. The second intersection H21 may be arranged to have a safe distance from the second contour N. The target second intersection H21 having the minimum distance from the second contour N is arranged to have a safe distance from the second contour N, which means that any second intersection H2 in the plurality of second intersections H2 has a distance greater than the safe distance from the second contour N.

That is, in the case where the orthographic projection of the protective structure 50 on the substrate 10 does not cover the plurality of second intersections H2 of the signal line 31, the border (the second contour N) of the protective structure 50 may be arranged to have a safe distance from the orthographic projection of the target second intersection H21 that is not covered by the protective structure 50 on the substrate 10.

This design is equivalent to adjusting the signal line 31 such that the second intersection H2 that may overlap with the second contour N moves outward, so as to ensure that the target second intersection H21 moves outward to the outside of the second contour N and the target second intersection H21 has a safe distance from the second contour N. That is, each second intersection H2 may have a distance equal to or greater than the safe distance from the second contour N.

Based on this, it is possible to prevent the border (the second contour N) of the protective structure 50 from overlapping with the second intersection H2 of the signal line 31, which may prevent the border (the second contour N) of the protective structure 50 from being located in the groove Q at a position corresponding to the second intersection H2 of the signal line 31, thereby reducing the probability of cracking appearing in the protective structure 50 to increase the service life of the light-emitting chip 40.

In some other embodiments, as shown in FIGS. 13 and 14, orthographic projections of some intersections H of the signal lines 31 on the substrate 10 are located inside of the second contour N, and orthographic projections of some other intersections H of the multiple signal lines 31 in a signal line group 30 on the substrate 10 are non-overlapping with the orthographic projection of the protective structure 50 on the substrate 10; that is, the orthographic projections of the some other intersections H of the multiple signal lines 31 of the signal line group 30 on the substrate 10 are all located outside of the second contour N.

The intersection H located inside of the second contour N is defined as a first intersection H1, and the intersection H outside of the second contour N is defined as a second intersection H2.

In this case, the plurality of first intersections H1 include at least one target first intersection H11 having a minimum distance from the second contour N, and the plurality of second intersections H2 include at least one target second intersection H21 having a minimum distance from the second contour N.

The first intersection H11 may be arranged to have a safe distance from the second contour N, and the second intersection H21 may be arranged to have a safe distance from the second contour N. On this basis, any first intersection H1 in the plurality of first intersections H1 may have a distance greater than the safe distance from the second contour **N,** and any second intersection H2 in the plurality of second intersections H2 may have a distance greater than the safe distance from the second contour N.

With this design, it is possible to prevent the border (the second contour N) of the protective structure 50 from overlapping with the intersections H (the first intersection H1 and the second intersection H2) of the signal line 31, which may prevent the border (the second contour N) of the protective structure 50 from being located in the groove Q at the position corresponding to the intersections H (the first intersection H1 and the second intersection H2) of the signal line 31, thereby reducing the probability of cracking appearing in the protective structure 50 to increase the service life of the light-emitting chip 40.

FIG. 15 is a structural diagram showing a region of a light-emitting substrate that is covered by red ink after performing a reliability test on the light-emitting substrate under a high temperature and high humidity, in accordance with some embodiments.

After performing a reliability test on the light-emitting substrate 100 provided by the embodiments of the present disclosure under a high temperature and high humidity for about 12 hours, it can be found that the red ink is basically blocked by the protective structure 50 outside of the border (the second contour N) of the protective structure 50. Therefore, the protective structure 50 may effectively protect the light-emitting chip 40 from being damaged by water and oxygen, thereby ensuring the service life of the light-emitting chip 40.

In summary, in the case where the light-emitting substrate 100 provided by the embodiments of the present disclosure is provided with the protective structure 50, it is possible to adjust the positions of the border (the second contour N) of the protective structure 50 and the orthographic projection of the intersection H of the signal line 31 on the substrate 10 to ensure a safe distance between the two. In this way, the problem of cracking appearing in the protective structure 50 may be alleviated, which may improve the reliability of the protective structure 50, thereby ensuring that the protective structure 50 plays the role of protecting the light-emitting chip 40 to improve the quality of the light-emitting substrate 100.

In some embodiments, as shown in FIGS. 9 to 13, a length d of the safe distance is greater than or equal to 0.3 mm, such as 0.35 mm, 0.4 mm, 0.45 mm or 0.5 mm.

In a case where the distance between the second contour N corresponding to the protective structure 50 and the intersection H (the target first intersection H11 or the target second intersection H21) of the signal line 31 is equal to or close to 0.3 mm, it may be ensure that the second contour N corresponding to the protective structure 50 still has a distance from the intersection H (the target first intersection H11 or the target second intersection H21) of the signal line 31 even if there is a manufacturing process error, thereby ameliorating the situation where the second contour N corresponding to the protective structure 50 overlaps with the orthographic projection of the intersection H (the first intersection H1 or the second intersection H2) of the signal line 31 on the substrate 10.

Moreover, a problem of that there is a need to drastically adjust the layout of the signal lines 31 caused by a case that the required safe distance is too great will not occur. That is, the layout of the signal lines 31 in the light-emitting substrate 100 may be adjusted slightly to alleviate the problem of cracking in the protective structure 50. Based on this, the probability of cracking appearing in the protective structure 50 may be reduced, so that the protective structure 50 may well protect the light-emitting chip 40 to improve the quality of the light-emitting substrate 100.

In some examples, the length d of the safe distance is any one of approximately 0.35 mm, 0.4 mm, 0.45 mm, 0.5 mm, 0.55 mm, 0.6 mm, 0.65 mm or 0.7 mm, and the embodiments of the present disclosure are not limited thereto.

For example, the length d of the safe distance is approximately 0.3 mm. In this case, the layout of the signal line 31 in the light-emitting substrate 100 may be slightly adjusted to alleviate the problem of cracking in the protective structure 50.

It will be noted that, due to the existence of certain uncontrollable errors (e.g., manufacturing process errors, equipment precision, or measurement errors), the deviation of the length d of the safe distance is within approximately 10% of 0.3 mm, which may also be considered as that the length d of the safe distance is equal 0.3 mm.

In the above embodiments, the case where the intersection H of the first contour M of the signal line 31 and the border (the second contour N) of the protective structure 50 have a safe distance therebetween is described in conjunction with relevant drawings. That is, the orthographic projection of the corner V of the signal line 31 on the substrate 10 is arranged to have a safe distance from the second contour N of the protective structure 50 to alleviate the problem of the protective structure 50 being prone to cracking. The corresponding arrangement relationship between the corresponding protective structure 50 and signal line 31 according to different arrangements of the signal lines 31 in the light-emitting substrate 100 will be described below, aiming to further alleviate the problem of the protective structure 50 being prone to cracking.

In some embodiments, as shown in FIGS. 9 and 11, a sum of areas of orthographic projections of the plurality of signal lines 31 in the light-emitting substrate 100 on the substrate 10 accounts for more than 30% of the light-emitting substrate 100. For example, the sum of areas of orthographic projections of the plurality of signal lines 31 in the light-emitting substrate 100 on the substrate 10 accounts for approximately 45% of the light-emitting substrate 100.

Since the signal line 31 in the light-emitting substrate 100 is generally made of metal, and metal generally has a good heat dissipation effect. In such a design, the width of the signal line 31 is great, which may reduce the impedance of the signal line 31, so that the signal line 31 may well carry a high current to improve the luminous effect of the light-emitting substrate 100; moreover, the heat dissipation effect of the light-emitting substrate 100 may also be improved.

In some embodiments, as shown in FIGS. 9 to 12, the second contour N includes a plurality of first portions N1 and a plurality of second portions N2 that are alternately connected end to end, any first portion N1 is located in an orthographic projection of a signal line 31 of the signal line group 30 on the substrate 10, and a second portion N2 is non-overlapping with an orthographic projection of any signal line 31 of the signal line group 30 on the substrate 10; a sum of the lengths of the plurality of first portions N1 is greater than a sum of the lengths of the plurality of second portions N2.

The above arrangement is equivalent to dividing the second contour N of the orthographic projection of the protective structure 50 on the substrate 10 into two portions, the two portions are respectively a first portion N1 and a second portion N2, the first portion N1 of the second contour N is a portion of the second contour N that overlaps with the orthographic projection of the signal line 31 on the substrate 10, and the second portion N2 of the second contour N is a portion of the second contour N that is non-overlapping with the orthographic projection of the signal line 31 on the substrate 10.

In the same second contour, the sum of the lengths of the plurality of first portions N1 is greater than the sum of the lengths of the plurality of second portions N2. That is, a portion of the second contour that overlaps with the orthographic projection of the signal line 31 on the substrate 10 is larger than a portion of the second contour N that is non-overlapping with the orthographic projection of the signal line 31 on the substrate 10, which also mean that a portion of the protective structure 50 that overlaps with the orthographic projection of the signal line 31 on the substrate 10 is larger than a portion of the protective structure 50 that is non-overlapping with the orthographic projection of the signal line 31 on the substrate 10.

Based on this, it can be known that the area of the orthographic projection of the signal line 31 on the substrate 10 is great. That is, the signal line 31 has a large width, which helps to improve the heat dissipation effect of the light-emitting substrate 100 and reduces the impedance of the signal line 31, so that the signal line 31 may well carry a higher current to improve the luminous effect of the light-emitting substrate 100.

In some embodiments, referring to FIGS. 9 and 10, in the case where the sum of the lengths of the plurality of first portions N1 is greater than the sum of the lengths of the plurality of second portions N2, the second contour is in a shape of a circle, there is at least one target second portion N2, and the target second portion N2 has a safe distance d from the target first intersection H11 of the first contour M exactly, the length of the target second portion N2 satisfies the following

formula: $\dfrac{\alpha \pi R}{180} = \dfrac{\theta \pi R}{90} = \dfrac{\pi R \cos^{-1}\frac{R-d}{R}}{90}$ , where $\alpha$ is a central angle corresponding to the second portion N2, $\theta$ is half of the central angle corresponding to the second portion N2, R is the radius of the second contour N, and d is the length of the safe distance.

Based on this, a ratio of the length L1 of the second portion N2 to the circumference C of the second contour N is set to satisfy the following formula:

$\dfrac{L1}{C} \leq \dfrac{\cos^{-1}\frac{R-d}{R}}{180}$ , where R is the radius of the second contour N, and d is the length of the safe distance.

That is, the circumference C of the second contour N corresponding to the protective structure 50 is greater than the circumference of the second contour N having the target second portion N2. The size of this protective structure 50 is larger than the size of the protective structure 50 having the target second portion N2, which is equivalent to relatively increasing the maximum span of the second contour N corresponding to the protective structure 50 in a direction perpendicular to the arrangement direction of the two pads 21 of the pad group 20, so that the maximum span of the second contour N corresponding to the protective structure 50 is greater than the length of a portion of the signal line 31 covered by the protective structure 50, and thus the target first intersection H11 is ensured to be moved inward to have a distance greater than or equal to the safe distance d from the second contour N.

In the case where the distance between the target first intersection H11 and the second contour N is greater than or equal to the safe distance d, any first intersection H1 in the plurality of first intersections H1 may have a distance equal to or greater than the safe distance d from the second contour N.

Based on this, it is possible to prevent the border (the second contour N) of the protective structure 50 from overlapping with the first intersection H1 of the signal line 31, which may prevent the border (the second contour N) of the protective structure 50 from being located in the groove Q at the position corresponding to the first intersection H1 of the signal line 31, thereby reducing the probability of cracking appearing in the protective structure 50 to increase the service life of the light-emitting chip 40.

It will be noted that, the description of "relatively increasing the maximum span of the second contour N corresponding to the protective structure 50 in the direction perpendicular to the arrangement direction X of the two pads 21 of the pad group 20" may include the following two ways.

The first way is to increase the maximum span of the second contour N corresponding to the protective structure 50 in the direction perpendicular to the arrangement direction X of the two pads 21 of the pad group 20, so that the distance between the first intersection H1 (the target first intersection H11) and the second contour N is greater than or equal to the safe distance d. That is, by adjusting the protective structure, the area of orthographic projection of the protective structure 50 on the substrate 10 is increased, so as to increase the distance between the border (the second contour N) of the protective structure 50 and the first intersection H1 covered by protective structure 50 to be greater than or equal to the safe distance d.

The second way is to reduce the width of the portion of signal line 31 that is covered by the protective structure 50, so that the distance between the first intersection H1 (the target first intersection H11) and the second contour N is greater than or equal to the safe distance d. That is, by adjusting the signal line 31 and reducing the width of the signal line 31, the distance between the border (the second contour N) of the protective structure 50 and the first intersection H1 covered by the protective structure 50 is increased to be greater than or equal to the safe distance d.

In some embodiments, referring to FIGS. 11 and 12, in the case where the sum of the lengths of the plurality of first portions N1 is greater than the sum of the lengths of the plurality of second portions N2, there is a target second portion N2, and the target second portion N2 has the safe distance d from the target second intersection H21 of the first contour M exactly, the length of the target second portion N2 satisfies the following formula:

$$\frac{\alpha \pi R}{180} = \frac{\theta \pi R}{90} = \frac{\pi R \left(90 - \cos^{-1}\frac{G}{2R}\right)}{90}$$ , where $\alpha$ is a

central angle corresponding to the second portion N2, $\theta$ is half of the central angle corresponding to the second portion N2, R is the radius of the second contour N, and G is a distance between two signal lines 31 in a signal line group 30.

Based on this, a ratio of the length L1 of the second portion N2 to the circumference C of the second contour N is set to satisfy the following formula:

$$\frac{L1}{C} \geq \frac{90° - \cos^{-1}\frac{G}{2R}}{180}$$ , where R is the radius of the second contour N, and G is the distance between two signal lines 31 in a signal line group 30.

That is, the circumference C of the second contour N corresponding to the protective structure 50 is less than the circumference of the second contour N having the target second portion N2. The size of this protective structure 50 is smaller than the size of the protective structure 50 having the target second portion N2, which is equivalent to relatively reducing the maximum span of the second contour N corresponding to the protective structure 50 in the direction perpendicular to the arrangement direction of the two pads 21 of the pad group 20, so that the maximum span of the second contour N corresponding to the protective structure 50 is less than the length of the portion of signal line 31 covered by the protective structure 50, and thus the second intersection H2 (the target second intersection H21) is ensured to be moved outward to have a distance greater than or equal to the safe distance d from the second contour N.

In the case where the distance between the target second intersection H21 and the second contour N is greater than or equal to the safe distance d, any second intersection H2 in the plurality of second intersections H2 may have a distance equal to or greater than the safe distance d from the second contour N.

Based on this, it is possible to prevent the border (the second contour N) of the protective structure 50 from overlapping with the second intersection H2 of the signal line 31, which may prevent the border (the second contour N) of the protective structure 50 from being located in the groove Q at the position corresponding to the second intersection H2 of the signal line 31, thereby reducing the probability of cracking appearing in the protective structure 50 to increase the service life of the light-emitting chip 40.

It will be noted that, the description of "relatively reducing the maximum span of the second contour N corresponding to the protective structure 50 in the direction perpendicular to the arrangement direction X of the two pads 21 of the pad group 20" may include the following two ways.

The first way is to reduce the maximum span of the second contour N corresponding to the protective structure 50 in the direction perpendicular to the arrangement direction X of the two pads 21 of the pad group 20, so that the distance between the second intersection H2 (the target second intersection H21) and the second contour N is greater than or equal to the safe distance d. That is, by adjusting the protective structure, the area of orthographic projection of the protective structure 50 on the substrate 10 is reduced, so as to increase the distance between the border (the second contour N) of the protective structure 50 and the second intersection H2 that is not covered by protective structure 50 to be greater than or equal to the safe distance d.

The second way is to increase the width of the portion of signal line 31 that is covered by the protective structure 50, so that the distance between the second intersection H2 (the target second intersection H21) and the second contour N is greater than or equal to the safe distance d. That is, by adjusting the signal line 31 and increasing the width of the signal line 31, the distance between the border (the second contour N) of the protective structure 50 and the second intersection H2 that is not covered by the protective structure 50 is increased to be greater than or equal to the safe distance d.

In some examples, referring to FIGS. 11 and 12, a distance G between two signal lines 31 in a signal line group 30 may be a distance between two signal lines 31 in a signal line group 30 that need to be connected to the pad group 20. The distance G is approximately 130 μm.

In the case where the distance between two signal lines 31 in a signal line group 30 that need to be connected to the pad group 20 is equal to or close to 130 μm, the dimensional requirement of the light-emitting chip 40 to which the signal line group 30 needs to be connected may be met, thereby avoiding a void solder problem between the light-emitting chip 40 and the pads 21 connected to the signal lines 31 to improve the quality of the light-emitting substrate 100.

In some embodiments, as shown in FIGS. 9 and 11, a signal line 31 connected to a pad 21 is divided into a plurality of sub-portions 311 connected in sequence, and extension directions of two sub-portions 311 connected to each other intersect. In the plurality of sub-portions 311, a sub-portion 311 connected to the pad 21 is a first sub-portion 311a, and in an arrangement direction X of the two pads 21 of the pad group 20, a width of the first sub-portion 311a is greater than a length of the pad 21.

With this arrangement, it may be possible to increase the dimension of the sub-portion 311 (the first sub-portion 311a) connected to the pad 21, which facilitates the subsequent connection between the signal line 31 to the pad 21 and ameliorates the problem of void solder, thereby improving the quality of the light-emitting substrate 100.

In some examples, the pad 21 may be electrically connected to the first sub-portion 311a of the signal line 31 by solder. The material of the solder is a conductive material, so that the pad 21 and the first sub-portion 311a of the signal line 31 may be fixedly and electrically connected through the solder. For example, the material of the solder may include tin, gold, silver, or copper.

In some embodiments, as shown in FIGS. 9 and 11, in the plurality of sub-portions 311, the sub-portion 311 connected to the pad 21 is the first sub-portion 311a, and the remaining sub-portion 311 except the first sub-portion 311a is a second sub-portion 311b. A width of the second sub-portion 311b is less than or equal to the width of the first sub-portion 311a.

In the case where the width of the second sub-portion 311b is set to be less than the width of the first sub-portion 311a, the width of the remaining portion of the signal line 31 except the sub-portion (the first sub-portion 311a) connected to the pad 21 is small, which may facilitate the flexible arrangement of the signal line 31 to simplify the layout of the light-emitting substrate 100.

In addition, the other end (the second sub-portion 311b) of the signal line 31 away from the first sub-portion 311a may need to be electrically connected to a driver chip, the width of the second sub-portion 311b is set to be small, which may also facilitate the connection between the signal line 31 and the pin of the driver chip to avoid the problem of short circuit.

In the case where the width of the second sub-portion 311b is set to be substantially equal to the width of the first sub-portion 311a, the width of the signal line 31 is substantially the same at every position, so that the width of the signal line 31 is large, which is conducive to reducing the impedance of the signal line 31 to allow the signal line 31 to carry a high current to meet the requirements of the light-emitting substrate 100. In addition, the light-emitting substrate 100 may also use the signal line 31 for heat dissipation to improve the heat dissipation effect of the light-emitting substrate 100 and reduce the cost of the light-emitting substrate 100.

In some embodiments, as shown in FIG. 11, first sub-portions 311a of two signal lines 31 connected to two pads 21 in a pad group 20 may be arranged opposite to each other in the arrangement direction of the two pads 21. The first sub-portions 311a of the two signal lines 31 have a gap therebetween to avoid a short circuit problem between the two signal lines 31.

In the above structure, in the two signal lines 31, the first sub-portion 311a of the first signal line 31 includes a side edge proximate to the first sub-portion 311a of the second signal line 31, and the first sub-portion 311a of the second signal line 31 includes a side edge proximate to the first sub-portion 311a of the first signal line 31.

The pad 21 may be located on a side of the signal line 31 away from the substrate 10, and on this basis, an orthographic projection of the pad 21 on the substrate 10 may be arranged to be located in the orthographic projection of the signal line 31 to which the pad 21 is connected on the substrate 10. Based on this, an orthographic projection of a border of the pad 21 on the substrate 10 may be arranged to substantially coincide with an orthographic projection of the side edge of the signal line 31 to which the pad 21 is connected on the substrate 10.

That is, a distance between two pads 21 in a pad group 20 is substantially equal to a distance between first sub-portions 311a of two signal lines 31 connected to the pad group 20 in a signal line group 30. In this way, the distance between the two pads 21 may be reduced to facilitate matching the two pins of the corresponding light-emitting chip 40 and ameliorate the problem of void solder.

In some embodiments, as shown in FIG. 11, the first sub-portions 311a of the two signal lines 31 connected to the two pads 21 of the pad group 20 may be arranged opposite to each other in the arrangement direction of the two pads 21. The second sub-portions 311b of the two signal lines 31 may be respectively located on two sides of the light-emitting chip 40 in a direction perpendicular to the arrangement direction of the two pads 21.

That is, the remaining portions of the two signal lines 31 except the first sub-portions 311a that need to be directly connected to the pads 21 may be arranged along two edges of the light-emitting chip 40. Thus, it may be possible to facilitate the arrangement of the signal lines 31 in the light-emitting substrate 100 and prevent the signal line 31 connected to the light-emitting chip 40 from being routed to avoid other light-emitting chips 40, thereby simplifying the layout of the light-emitting substrate 100.

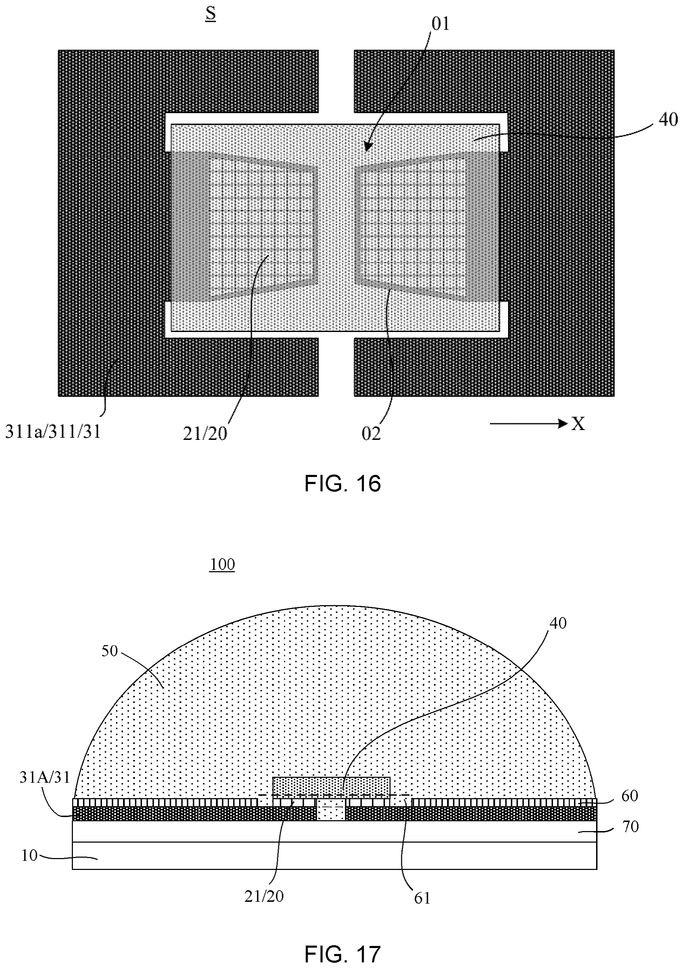

FIG. 16 is a partial enlarged view of the region S in FIG. 9. In order to clearly illustrate the structure of the connection line 31 and the connection between the connection line 31 and the pad 21, the protective structure 50 is not illustrated in FIG. 16.

In some embodiments, as shown in FIGS. 9 and 16, for two signal lines 31 connected to two pads 21 of the pad group 20, an opening 01 is provided at an edge of one signal line 31 proximate to the other signal line 31, and a connection portion 02 connected to the first signal line 31 is provided in the opening 01. The pad 21 is located on a side of the connection portion 02 away from the substrate 10. Two pins of the light-emitting chip 40 are respectively electrically connected to the two connection portions 02 through respective pads 21, so that the light-emitting chip 40 is electrically connected to the two signal lines 31.

With such a configuration, the opening 01 of the signal line 31 may have a limit function to prevent the pin of the light-emitting chip 40 from being connected to the connection line 31 at a position where the connection line 31 is located, thereby ensuring that the pin of the light-emitting chip 40 is electrically connected to the connection portion 02 located in the opening 01, so as to reduce the probability of void solder in the light-emitting chip 40.

In some examples, in the arrangement direction X of the two pads 21 of the pad group 20, a length of the connection portion 02 is substantially equal to a length of the opening 01. Based on this, the dimension of the connection portion 02 may be large, thereby ensuring the dimension of the pad 21 disposed on the connection portion 02 to facilitate the subsequent electrical connection between the light-emitting chip 40 and the pad 21.

In some examples, the openings 01 of the two signal lines 31 connected to the two pads 21 of the pad group 20 have a gap therebetween, so that the two connection portions 02 located in the two openings 01 are ensured to have a gap therebetween. In this way, it is possible to avoid the problem of short circuit between the two pins of the light-emitting chip 40 after the two pins of the light-emitting chip 40 are connected to the two connection portions 02.

In some other embodiments, as shown in FIGS. 13 and 14, the sum of areas of orthographic projections of the plurality of signal lines 31 in the light-emitting substrate 100 on the substrate 10 accounts for 30% or less than 30% of the light-emitting substrate 100. For example, the sum of areas of orthographic projections of the plurality of signal lines 31 in the light-emitting substrate 100 on the substrate 10 accounts for approximately 25% to 30% of the light-emitting substrate 100. With this design, the signal line 31 has a small width and a high design flexibility, thereby preventing the interference between the signal line 31 and other devices in the light-emitting substrate 100 in layout, so as to avoid the problem of short circuit.

In some embodiments, as shown in FIGS. 13 and 14, the second contour N includes a plurality of first portions N1 and a plurality of second portions N2 that are alternately connected end to end, any first portion N1 is located in an orthographic projection of a signal line 31 of the signal line group 30 on the substrate 10, and a second portion N2 is non-overlapping with the orthographic projection of any signal line 31 of the signal line group 30 on the substrate 10; the sum of the lengths of the plurality of first portions N1 is less than the sum of the lengths of the plurality of second portions N2.

The above arrangement is equivalent to dividing the second contour N of the orthographic projection of the protective structure 50 on the substrate 10 into two portions, the two portions are respectively a first portion N1 and a second portion N2, the first portion N1 of the second contour N is a portion of the second contour N that overlaps with the orthographic projection of the signal line 31 on the substrate 10, and the second portion N2 of the second contour N is a portion of the second contour N that is non-overlapping with the orthographic projection of the signal line 31 on the substrate 10.

In the same second contour, the sum of the lengths of the plurality of first portions N1 is less than the sum of the lengths of the plurality of second portions N2. That is, a portion of the second contour that overlaps with the orthographic projection of the signal line 31 on the substrate 10 is smaller than a portion of the second contour N that is non-overlapping with the orthographic projection of the signal line 31 on the substrate 10, which also mean that a portion of the protective structure 50 that overlaps with the orthographic projection of the signal line 31 on the substrate 10 is smaller than a portion of the protective structure 50 that is non-overlapping with the orthographic projection of the signal line 31 on the substrate 10.

Based on this, it can be known that the area of the orthographic projection of the signal line 31 on the substrate 10 is small. That is, the signal line 31 has a small width, which helps to improve the layout flexibility of the signal line 31 and avoids the problem of short circuit of the signal line 31. In addition, it is possible to further alleviate the problem that the corner C (the intersection H) of the signal line 31 overlaps with the border (the second contour N) of the protective structure 50 to reduce the probability of cracking of the protective structure 50 and improve the quality of the light-emitting substrate 100.

In some embodiments, as shown in FIG. 13, the signal line 31 connected to the pad 21 is divided into a plurality of sub-portions 311 connected in sequence, and extension directions of two sub-portions 311 connected to each other intersect. The plurality of sub-portions 311 include a third sub-portion 311c and a fourth sub-portion 311d, and the fourth sub-portion 311d is used to connect the pad 21 and the third sub-portion 311c. An orthographic projection of the third sub-portion 311c on the substrate 10 is non-overlapping with the orthographic projection of the protective structure 50 on the substrate 10.

In the above structure, since the orthographic projection of the third sub-portion 311c on the substrate 10 is located outside of the second contour N, the intersection H included in the third sub-portion 311c is a second intersection H2. An orthographic projection of the second intersection H2 of the third sub-portion 311c on the substrate 10 has a safe distance from the second contour N corresponding to the protective structure 50. Based on this, it is possible to prevent the border (the second contour N) of the protective structure 50 from overlapping with the second intersection H2 of the signal line 31, which may prevent the border (the second contour N) of the protective structure 50 from being located in the groove Q at the position corresponding to the second intersection H2 of the signal line 31, thereby reducing the probability of cracking of the protective structure 50 and increasing the service life of the light-emitting chip 40.

Furthermore, on the basis that the orthographic projection of the second intersection H2 of the third sub-portion 311c on the substrate 10 is arranged to have a safe distance from the second contour N corresponding to the protective structure 50, the third sub-portion 311c may be arranged to have a safe distance from the second contour N.

With such an arrangement, not only the distance between the orthographic projection of the second intersection H2 of the third sub-portion 311c on the substrate 10 and the second contour N corresponding to the protective structure 50 may be further increased to be greater than or equal to the safe distance, but also the distance between the second contour N2 and the edge M1 of the third sub-portion 311c may be increased to prevent the second contour N corresponding to the protective structure 50 from overlapping with the edge M1 of the third sub-portion 311c, thereby avoiding the problem of cracking at the border (the second contour N) of the protective structure 50 due to the level difference formed by the edge M1 of the third sub-portion 311c and the substrate.

In the above structure, the relative positional relationship between the fourth sub-portion 311d and the protective structure 50 includes the following two situations.

First situation: in the same signal line 31, in a case where the plurality of sub-portions 311 include 1 fourth sub-portion 311d, an end of the fourth sub-portion 311d is connected to the pad 21, and the other end of the fourth sub-portion 311d is connected to the third sub-portion 311c. Since the third sub-portion 311c and the second contour N have a safe distance therebetween, there is a need to arrange an end of the fourth sub-portion 311d that is connected to the third sub-portion 311c to extends to the outside of the second contour N.

Based on this, the fourth sub-portion 311d includes two sections. An orthographic projection of a section of the fourth sub-portion 311d on the substrate 10 is located in the orthographic projection of the protective structure 50 on the substrate 10; that is, the section of the fourth sub-portion 311d is located inside of the second contour N. An orthographic projection of the other section of the fourth sub-portion 311d on the substrate 10 is non-overlapping with the orthographic projection of the protective structure 50 on the substrate 10; that is, the other section of the fourth sub-portion 311d is located outside of the second contour N.

In the above structure, the plurality of intersections H included in the fourth sub-portion 311d include a first intersection H1 and a second intersection H2. The first intersection H1 is located inside of the second contour **N,** and the second intersection H2 is located outside of the second contour N. In this case, there is a need to satisfy that both the first intersection H1 and the second intersection H2 have a safe distance from the second contour N.

With such a design, it may be possible to prevent the border (the second contour N) of the protective structure 50 from overlapping with the intersection H (the first intersection H1 or the second intersection H2) of the signal line 31, which may prevent the border (the second contour N) of the protective structure 50 from being located at the position corresponding to the intersection H (the first intersection H1 or the second intersection H2) of the signal line 31, thereby reducing the probability of cracking of the protective structure 50 to increase the service life of the light-emitting chip 40.

Second situation: in the same signal line 31, in a case where the plurality of sub-portions 311 include at least 2 fourth sub-portions 311d, the plurality of fourth sub-portions 311d include a fourth sub-portion 311d that needs to be in contact with and connected to the third sub-portion 311c; since the third sub-portion 311c has a safe distance from the second contour **N,** there is a need to arrange an end of the fourth sub-portion 311d that is in contact with and connected to the third sub-portion 311c to extend to the outside of the second contour N. That is, the fourth sub-portion 311d that is in contact with and connected to the third sub-portion 311c includes two sections, an orthographic projection of a section of the fourth sub-portion 311d that is in contact with and connected to the third sub-portion 311c on the substrate 10 is located in the orthographic projection of the protective structure 50 on the substrate 10, and an orthographic projection of the other section of the fourth sub-portion 311d that is in contact with and connected to the third sub-portion 311c on the substrate 10 is non-overlapping with the orthographic projection of the protective structure 50 on the substrate 10.

An orthographic projection of a fourth sub-portion 311d in the plurality of fourth sub-portions 311d that does not need to be in contact with and connected to the third sub-portion 311c on the substrate 10 is located in the orthographic projection of the protective structure 50 on the substrate 10. That is, the orthographic projection of the fourth sub-portion 311d in the fourth sub-portions 311d that is indirectly connected to the third sub-portion 311c on the substrate 10 is located in the orthographic projection of the protective structure 50 on the substrate 10.

Based on this, a plurality of intersections H included in the fourth sub-portion 311d that is in contact with and connected to the third sub-portion 311c include a first intersection H1 and a second intersection H2. The first intersection H1 is located inside of the second contour **N,** and the second intersection H2 is located outside of the second contour N. In this case, there is a need to satisfy that both the first intersection H1 and the second intersection H2 have a safe distance from the second contour N. Multiple intersections H included in the fourth sub-portion 311d that is indirectly connected to the third sub-portion 311c are all first intersections H1, and the first intersection H1 needs to be arranged to have a safe distance from the second contour N. With this arrangement, the probability of cracking of the protective structure 50 may be reduced, thereby increasing the service life of the light-emitting chip 40.

In some embodiments, as shown in FIG. 14, the signal line 31 connected to the pad 21 includes at least three sequentially connected sub-portions 311 (the fourth sub-portions 311d) inside of the second contour **N,** and extension directions of two sub-portions 311 connected to each other intersect.

In the above design, the orthographic projection of the protective structure 50 on the substrate 10 covers multiple sub-portions 311 of the signal line 31 connected to the pad 21. That is, multiple sub-portions 311, inside of the second contour **N,** of the signal line 31 are disposed surrounding the light-emitting chip 40. Since the signal line 31 has a certain thickness, the multiple sub-portions 311 inside of the second contour N may also serve as barrier walls to block external water vapor, thereby further preventing water vapor from affecting the service life of the light-emitting chip 40 and improving the quality of the light-emitting substrate 100.

In some embodiments, as shown in FIG. 14, multiple sub-portions 311 (the fourth sub-portions 311d), inside of the second contour **N,** of at least one signal line 31 connected to the pad group 20 may be arranged to surround at least a portion of the light-emitting chip 40 connected to the pad group 20.

This arrangement is equivalent to arranging the signal line(s) 31 connected to the pad group 20 and inside of the second contour N to surround the light-emitting chip 40. In this case, since the signal line 31 has a certain thickness, the multiple sub-portions 311 (the fourth sub-portions 311d) located inside of the second contour N may also serve as barrier walls to block external water vapor, thereby further preventing water vapor from affecting the service life of the light-emitting chip 40 and improving the quality of the light-emitting substrate 100.

The multiple sub-portions 311 (the fourth sub-portions 311d) of the at least one signal line 31 connected to the pad group 20 surround at least a portion of the light-emitting chip 40 connected to the pad group 20, which may include the following situations.

First situation: multiple sub-portions 311 (the fourth sub-portions 311d) of a signal line 31 connected to a pad 21 of the pad group 20 are arranged along an outer edge of at least a portion of the light-emitting chip 40 connected to the pad group 20.

That is, the multiple fourth sub-portions 311d of the signal line 31 may be arranged along a portion of the edge of the light-emitting chip 40, or the multiple fourth sub-portions 311d of the signal line 31 may be arranged surrounding the light-emitting chip 40.

Based on this, since the signal line 31 has a certain thickness, the multiple sub-portions 311 (the fourth sub-portions 311d) located inside of the second contour N may also serve as barrier walls to block external water vapor, thereby further preventing water vapor from affecting the service life of the light-emitting chip 40 and improving the quality of the light-emitting substrate 100.

Second situation: multiple sub-portions 311 (the fourth sub-portions 311d) of two signal lines 31 connected to two pads 21 of the pad group 20 surround at least a portion of the light-emitting chip 40 connected to the pad group 20.

That is, multiple sub-portions 311 (the fourth sub-portions 311d) of a signal line 31 connected to one pad 21 of the pad group 20 may be arranged along an outer edge of a portion of the light-emitting chip 40 connected to the pad group 20; and multiple sub-portions 311 (the fourth sub-portions 311d) of a signal line 31 connected to the other pad 21 in the same pad group 20 may be arranged along an outer edge of another portion of the same light-emitting chip 40.

This arrangement is equivalent to arranging two signal lines 31 inside of the second contour N and connected to two pads 21 of the pad group 20 to cooperate with each other to surround the light-emitting chip 40. In this case, since the signal line 31 has a certain thickness, the multiple sub-portions 311 (the fourth sub-portions 311d) located inside of the second contour N may serve as barrier walls. That is, arranging multiple sub-portions 311 inside of the second contour N along the circumference of the light-emitting chip is equivalent to arranging barrier walls along the circumference of the light-emitting chip.

In the above structure, not only the protective structure 50 may be used to protect the light-emitting chip 40, but also the multiple sub-portions 311 located inside of the second contour N may be used to block external water vapor, thereby further preventing water vapor from affecting the service life of the light-emitting chip 40 and improving the quality of the light-emitting substrate 100.

In some examples, 5 sub-portions 311 (the fourth sub-portions 311d) of the signal line 31 connected to one pad 21 of the pad group 20 are located inside of the second contour N.

In this way, the sequentially connected 5 sub-portions 311 (the fourth sub-portions 311d) may be arranged surrounding the light-emitting chip 40 to block water vapor. Moreover, it is possible to avoid the problem of short circuit caused by the excessively dense arrangement of the sub-portions 311 inside of the second contour N due to too many sub-portions 311 inside of the second contour N.

In some examples, as shown in FIG. 14, two pads 21 of the pad group 20 are respectively a first pad 21a and a second pad 21b. **In** this case, a signal line 31 connected to the first pad 21a is a first signal line 31a, and a signal line 31 connected to the second pad 21b is a second signal line 31b.

**In** the case where the multiple sub-portions 311 (the fourth sub-portions 311d) of the first signal line 31a are arranged along the outer edge of the portion of the light-emitting chip 40 connected to the pad group 20, a part of sub-portions 311 away from the pad 21 in the multiple sequentially connected sub-portions 311 (the fourth sub-portions 311d) of the first signal line 31a may be located between a portion (a part of sub-portions 311 proximate to the pad 21 in the multiple sequentially connected sub-portions 311) of the second signal line 31b and the second contour N.

**In** addition, in the case where multiple sub-portions 311 (the fourth sub-portions 311d) of the second signal line 31b are arranged along the outer edge of the another portion of the same light-emitting chip 40, a part of sub-portions 311 away from the pad 21 in the multiple sequentially connected sub-portions 311 (the fourth sub-portions 311d) of the second signal line 31b may be located between a portion (a part of sub-portions 311 proximate to the pad 21 in the multiple sequentially connected sub-portions 311) of the first signal line 31a and the second contour N.

With the above structure, the two signal lines 31 connected to the two pads 21 of the pad group 20 may completely surround the light-emitting chip 40, so that the water vapor may be prevented from entering from the alternately arranged sub-portions 311 of the two signal lines 31. On this basis, the signal lines 31 may be used to further prevent the service life of the light-emitting chip 40 from being affected by water vapor, thereby improving the quality of the light-emitting substrate 100.

In some embodiments, as shown in FIGS. 13 and 14, the signal line 31 connected to the pad 21 is divided into a plurality of sequentially connected sub-portions 311, and extension directions of two sub-portions 311 connected to each other intersect. **In** the plurality of sub-portions 311, a sub-portion 311 connected to the pad 21 is a first sub-portion 311a, and in a direction perpendicular to the extension direction of the first sub-portion 311a, a width of the first sub-portion 311a is substantially equal to the length of the pad 21.

**It** will be noted that, due to the existence of certain uncontrollable errors (e.g., manufacturing process errors, equipment precision, or measurement errors), a difference between the width of the first sub-portion 311a and the length of the pad 21 in the direction perpendicular to the extension direction of the first sub-portion 311a fluctuates within 10% of the width of the first sub-portion 311a or 10% of the length of the pad 21, which may also be considered as that the width of the first sub-portion 311a and the length of the pad 21 in the direction perpendicular to the extension direction of the first sub-portion 311a are equal.

**In** the above design, the width of the first sub-portion 311a connected to the pad 21 is substantially equal to the length of the pad 21, so that the requirement for connecting the pad 21 to the signal line 31 may be met. Furthermore, the width of the signal line 31 may be set small, which may facilitate flexible arrangement of the signal line 31.

**It** will be noted that, in the above embodiments, in the case where the signal line 31 includes 1 fourth sub-portion, the fourth sub-portion is the first sub-portion; and in the case where the signal line 31 includes a plurality of fourth sub-portions, a fourth sub-portion directly connected to the pad 21 in the plurality of fourth sub-portions is the first sub-portion.

In some embodiments, as shown in FIGS. 13 and 14, widths of any two sub-portions 311 of the same signal line 31 are substantially equal. With this design, the width of the signal line 31 may be the same at every position, which is conducive to simplifying the fabricating process of the signal line 31.

In addition, in the case where the width of the first sub-portion 311a and the length of the pad 21 in the direction perpendicular to the extension direction of the first sub-portion 311a are set to be substantially equal, the widths of any two sub-portions 311 of the same signal line 31 are set to be substantially equal. In this way, the width of the signal line 31 may be small, which may increase the flexibility of the arrangement of the signal line 31 to avoid other devices in the light-emitting substrate 100, so as to avoid problem of the short circuit.

It will be noted that, due to the existence of certain uncontrollable errors (e.g., manufacturing process errors, equipment precision, or measurement errors), a difference in width between any two sub-portions 311 of the same signal line 31 fluctuates within 10% of the width of any sub-portion 311, which may also be considered as that, in the direction perpendicular to the extension direction of the first sub-portion 311a, the width of the first sub-portion 311a is equal to the length of the pad 21.

In the above embodiments, the relative positional relationship between the signal line 31 and the protective structure 50 in the light-emitting substrate 100 are mainly described in conjunction with the drawings. Other structures in the light-emitting substrate 100 will be introduced below in conjunction with relevant drawings.

FIG. 17 is a sectional view of a light-emitting substrate, in accordance with some embodiments.

In some embodiments, as shown in FIG. 17, the light-emitting substrate 100 further includes a reflective layer 60, and the reflective layer 60 is located on a side of a film layer in which the signal line 31 is located away from the substrate 10. The reflective layer 60 includes a portion located on a side of the signal line 31 away from the substrate 10, and the reflective layer 60 further includes a portion located on the substrate 10 and in a gap between adjacent signal lines 31. The reflective layer 60 may reflect light emitted by the light-emitting chip 40 toward a light exit direction of the light-emitting substrate 100, thereby improving the light efficiency of the light-emitting substrate 100.

The reflective layer 60 includes a hollow region 61, and an orthographic projection of the pad 21 on the substrate 10 is located in an orthographic projection of the hollow region 61 on the substrate 10. The reflective layer 60 is pre-provided with an opening (the hollow region 61), thereby prevent the light emission of the light-emitting chip 40 from affecting caused by a fact that the connection between the signal line 31 and the pad 21 is affected due to the case that the reflective layer 60 is located between the signal line 31 and the pad 21.

In some examples, an orthographic projection of the light-emitting chip 40 on the substrate 10 is located in the orthographic projection of the hollow region 61 on the substrate 10. On this basis, it is possible to prevent the problem of void solder from occurring in the light-emitting chip 40, thereby facilitating improving the quality of the light-emitting substrate 100.

In some examples, the reflective layer 60 may be white, thereby achieving a high reflectivity.

For example, the reflective layer 60 may be made of a white ink, thereby achieving a high reflectivity. The white ink may include, for example, resin (e.g., epoxy resin, or polytetrafluoroethylene resin), titanium dioxide ($TiO_2$) and an organic solvent (e.g., dipropylene glycol methyl ether).

For another example, the material of the reflective layer 60 may include a silicone-based white adhesive. In the case where the material of the reflective layer 60 includes the white ink or the silicone-based white adhesive, the reflective layer 60 may be formed by printing the white ink or the silicone-based white adhesive by using a screen printing process.

In some embodiments, as shown in FIG. 17, the light-emitting substrate 100 further includes an insulating layer 70, and the insulating layer 70 is located between the signal line 31 and the substrate 10 (aluminum substrate). The insulating layer 70 may be used to prevent the signal line 31 from being connected to other conductive structures in the substrate 10 (aluminum substrate).

The above are only specific embodiments of the present disclosure, but the protection scope of the present disclosure is not limited thereto, and variations or substitutions that any person skilled in the art may conceive of within the technical scope of the present disclosure should all fall within the protection scope of the present disclosure. Therefore, the protection scope of the present disclosure should be subjected to the protection scope of the claims.

**Claims**

1. A light-emitting substrate, comprising:

   a substrate;
   a pad group and a light-emitting chip, wherein the pad group includes two pads respectively connected to two pins of the light-emitting chip;
   a signal line group including two signal lines at least, the two signal lines being respectively connected to the two pads of the pad group, wherein any adjacent signal lines have a gap therebetween, an orthographic projection of any signal line of the signal line group on the substrate has a first contour, the first contour includes a plurality of edges that are sequentially connected, any edge is a line without a corner point, any two connected edges have an intersection, and extension directions of the two edges at the intersection have an angle; and

a protective structure located on a side of the light-emitting chip away from the substrate, wherein an orthographic projection of the light-emitting chip on the substrate is located in an orthographic projection of the protective structure on the substrate;

wherein the orthographic projection of the protective structure on the substrate has a second contour, intersections include a target first intersection located inside of the second contour and having a minimum distance from the second contour, and the target first intersection has a safe distance from the second contour, and/or the intersections further include a target second intersection located outside of the second contour and having a minimum distance from the second contour, and the target second intersection has a safe distance from the second contour.

2. The light-emitting substrate according to claim 1, wherein

the second contour includes a plurality of first portions and a plurality of second portions that are alternately connected end to end, any first portion is located in an orthographic projection of a signal line of the signal line group on the substrate, and a second portion is non-overlapping with the orthographic projection of any signal line of the signal line group on the substrate; a sum of lengths of the plurality of first portions is greater than a sum of lengths of the plurality of second portions.

3. The light-emitting substrate according to claim 2, wherein the second contour is in a shape of a circle, and a ratio of a length L1 of the second portion to a circumference C of the second contour satisfies a following formula:

$$\frac{L1}{C} \leq \frac{\cos^{-1}\frac{R-d}{R}}{180};$$

wherein R is a radius of the second contour, and d is a length of the safe distance.

4. The light-emitting substrate according to claim 2, wherein the second contour is in a shape of a circle, and a ratio of a length L1 of the second portion to a circumference C of the second contour satisfies a following formula:

$$\frac{L1}{C} \geq \frac{90° - \cos^{-1}\frac{G}{2R}}{180};$$

wherein R is a radius of the second contour, and G is a distance between two signal lines of the signal line group.

5. The light-emitting substrate according to any one of claims 2 to 4, wherein a signal line connected to a pad is divided into a plurality of sub-portions connected in sequence, and extension directions of two sub-portions connected to each other intersect; and

in the plurality of sub-portions, a sub-portion connected to the pad is a first sub-portion, and in an arrangement direction of the two pads of the pad group, a width of the first sub-portion is greater than a length of the pad.

6. The light-emitting substrate according to claim 5, wherein a remaining sub-portion in the plurality of sub-portions except the first sub-portion is a second sub-portion; and

a width of the second sub-portion is less than or equal to the width of the first sub-portion.

7. The light-emitting substrate according to claim 1, wherein

the second contour includes a plurality of first portions and a plurality of second portions that are alternately connected end to end, any first portion is located in an orthographic projection of a signal line of the signal line group on the substrate, and a second portion is non-overlapping with the orthographic projection of any signal line of the signal line group on the substrate; a sum of lengths of the plurality of first portions is less than a sum of lengths of the plurality of second portions.

8. The light-emitting substrate according to claim 7, wherein a signal line connected to a pad is divided into a plurality of sub-portions connected in sequence, and extension directions of two sub-portions connected to each other intersect; and

the plurality of sub-portions include a third sub-portion, an orthographic projection of the third sub-portion on the substrate is non-overlapping with the orthographic projection of the protective structure on the substrate, and the third sub-portion has a safe distance from the second contour.

9. The light-emitting substrate according to claim 7 or 8, wherein a signal line connected to a pad includes at least three sub-portions connected in sequence inside of the second contour, and extension directions of two sub-portions connected to each other intersect.

10. The light-emitting substrate according to claim 9, wherein multiple sub-portions, inside of the second contour, of at least one signal line connected to the pad group are arranged surrounding at least a portion of the light-emitting chip connected to the pad group.

11. The light-emitting substrate according to any one of claims 8 to 10, wherein the signal line connected to the pad is divided into the plurality of sub-portions connected in sequence, and extension directions of two sub-portions connected to each other intersect; and

    in the plurality of sub-portions, a sub-portion connected to the pad is a first sub-portion, and in a direction perpendicular to an extension direction of the first sub-portion, a width of the first sub-portion is substantially equal to a length of the pad.

12. The light-emitting substrate according to any one of claims 8 to 11, wherein widths of any two sub-portions of a same signal line are substantially equal.

13. The light-emitting substrate according to any one of claims 1 to 12, wherein a length of the safe distance is greater than or equal to 0.3 mm.

14. The light-emitting substrate according to any one of claims 1 to 13, further comprising:
    a reflective layer located on a side of the signal line away from the substrate, wherein the reflective layer includes a hollow region, and an orthographic projection of a pad on the substrate is located in an orthographic projection of the hollow region on the substrate.

15. The light-emitting substrate according to any one of claims 1 to 14, wherein a thickness of the signal line is greater than or equal to 20 $\mu$m.

16. The light-emitting substrate according to any one of claims 1 to 15, wherein a contour of a cross-section of the protective structure along a plane perpendicular to the substrate protrudes toward a direction away from the substrate.

17. A backlight module, comprising the light-emitting substrate according to any one of claims 1 to 16.

18. A display apparatus, comprising:

    the backlight module according to claim 17; and
    a liquid crystal display panel located on a light exit side of the backlight module.

19. A display apparatus, comprising:
    a display panel, wherein the display panel includes the light-emitting substrate according to any one of claims 1 to 16.

1000

FIG. 1

1000

220

230

210

300

200

FIG. 2

1000

FIG. 3

FIG. 4

A-A'

FIG. 5

FIG. 6

FIG. 7

FIG. 8

FIG. 9

FIG. 10

FIG. 11

FIG. 12

FIG. 13

FIG. 14

FIG. 15

S                                    01

40

311a/311/31          21/20          02          → X

FIG. 16

100

50                                    40

31A/31                                60

                                       70

10

21/20          61

FIG. 17

## INTERNATIONAL SEARCH REPORT

| International application No. |
|---|
| **PCT/CN2023/129436** |

**A. CLASSIFICATION OF SUBJECT MATTER**

H01L33/54(2010.01)i

According to International Patent Classification (IPC) or to both national classification and IPC

**B. FIELDS SEARCHED**

Minimum documentation searched (classification system followed by classification symbols)

IPC:H01L33/-

Documentation searched other than minimum documentation to the extent that such documents are included in the fields searched

Electronic data base consulted during the international search (name of data base and, where practicable, search terms used)

CNKI; CNABS; CNTXT; VEN; USTXT; WOTXT; EPTXT: 投影, 俯视, 保护结构, 透镜, 反射, 焊垫, 焊盘, projection, top view, protective structure, lens, reflect, pad

**C. DOCUMENTS CONSIDERED TO BE RELEVANT**

| Category* | Citation of document, with indication, where appropriate, of the relevant passages | Relevant to claim No. |
|---|---|---|
| X | JP 2019186333 A (ASAHI KASEI CORP.) 24 October 2019 (2019-10-24) description, paragraphs 10-39, and figures 1-9 | 1-19 |
| X | CN 214956944 U (LITE-ON TECHNOLOGY CORP.) 30 November 2021 (2021-11-30) description, paragraphs 24-81, and figures 1-10 | 1-19 |
| X | JP 2013077813 A (MITSUBISHI CHEMICAL CORP.) 25 April 2013 (2013-04-25) description, paragraphs 17-27, and figures 1-7 | 1-19 |
| X | CN 101997074 A (APT ELECTRONICS CO., LTD.) 30 March 2011 (2011-03-30) description, paragraphs 22-37, and figures 1-4 | 1-19 |
| A | CN 114759135 A (GUANGZHOU CHINA STAR OPTOELECTRONICS SEMICONDUCTOR DISPLAY TECHNOLOGY CO., LTD.) 15 July 2022 (2022-07-15) entire document | 1-19 |
| A | JP 2011198834 A (CITIZEN ELECTRONICS et al.) 06 October 2011 (2011-10-06) entire document | 1-19 |

☐ Further documents are listed in the continuation of Box C.    ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **14 July 2024** | **20 July 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/129436**

| Patent document cited in search report | | | Publication date (day/month/year) | Patent family member(s) | | | Publication date (day/month/year) |
|---|---|---|---|---|---|---|---|
| JP | 2019186333 | A | 24 October 2019 | None | | | |
| CN | 214956944 | U | 30 November 2021 | CN | 114078997 | A | 22 February 2022 |
| | | | | CN | 215680687 | U | 28 January 2022 |
| | | | | US | 2022052230 | A1 | 17 February 2022 |
| | | | | US | 12009459 | B2 | 11 June 2024 |
| JP | 2013077813 | A | 25 April 2013 | TW | 201324879 | A | 16 June 2013 |
| | | | | WO | 2013039052 | A1 | 21 March 2013 |
| CN | 101997074 | A | 30 March 2011 | WO | 2012012975 | A1 | 02 February 2012 |
| | | | | US | 2012025241 | A1 | 02 February 2012 |
| CN | 114759135 | A | 15 July 2022 | WO | 2023206611 | A1 | 02 November 2023 |
| | | | | US | 2024162399 | A1 | 16 May 2024 |
| JP | 2011198834 | A | 06 October 2011 | None | | | |

Form PCT/ISA/210 (patent family annex) (July 2022)